# EUROPEAN PATENT APPLICATION

(11) **EP 4 845 326 A2**
(43) Date of publication of application: **25.11.2026**
(21) Application number: 26180682.2
(22) Date of filing: 22.05.2026
(51) Int. Cl.: H05K 7/20

(54) **SYSTEMS, UNITS, AND METHODS FOR IMMERSION COOLING AND SPOT COOLING**

(30) Priority: 22.05.2025 US 202563810502 P; 21.05.2026 US 202619684185
(71) Applicant: Google LLC, Mountain View, CA 94043 (US)
(72) Inventor: Khalili, Sadegh, Mountain View, 94043 (US); Iyengar, Madhusudan Krishnan, Mountain View, 94043 (US)
(74) Representative: Betten & Resch

(57) **Abstract**

Improved cooling systems, units, and components are disclosed, as well as methods of cooling, to improve overall cooling of IT equipment, such as servers and high-performance chips. Immersion cooling systems disclosed herein provide for a modified two-chamber immersion cooling unit, as well as improved targeted flow cooling. Additional immersion cooling unit systems disclose the combination of water cooling with immersion cooling using dielectric cooling fluids. Improved system components, such as chassis or cages for housing equipment with targeted cooling are also disclosed that alone or in combination with single or two-chamber immersion cooling units provide for enhanced cooling of components within the cage that are downstream of primary heated microelectronic devices.

## Description

### CROSS REFERENCE TO RELATED APPLICATIONS

The present application claims the benefit of the filing date of U.S. Provisional Patent Application No. 63/810,502, filed May 22, 2025, the disclosure of which is hereby incorporated herein by reference.

### BACKGROUND

Demand continues to increase for high performance computing ("HPC") systems, including artificial intelligence ("AI") systems, which require HPC and AI semiconductor chips to process vast amounts of data needed to perform calculations, simulations and the like. Modern-day processing units, such as central processing units ("CPUs"), tensor processing units ("TPUs"), graphical processing units ("GPUs"), and the like, alone or together, can be implemented in these systems to perform numerous applications, including machine learning and supercomputer applications. The increased performance demands necessarily increase power demands, which results in increased heat generated by these processors and systems implementing these processors. Numerous cooling technologies and systems have been developed to achieve cooling of these high-powered chips and systems.

One type of thermal cooling system is an immersion thermal management system, also known as a thermal convection system. Computer components, such as servers, motherboards, power modules, HPC chips, AI chips, memory cards, SDS cards, and various other computing components or equipment ("IT equipment") are housed and submerged within an immersion cooling tank or unit of thermally conductive dielectric cooling fluid that is fed into the immersion tank. The dielectric cooling fluid does not conduct electricity, but can conduct and absorb heat generated by the immersed IT equipment as the dielectric cooling fluid flows around and through the IT equipment. The heated dielectric cooling fluid, which is less dense and has a temperature greater than that of the initial temperature of dielectric cooling fluid, will rise to the top of the immersion unit. In a single phase immersion thermal management system, the heated dielectric cooling fluid is then pumped out of the tank and into a heat exchanger where the heated dielectric cooling fluid is cooled and fed back through the system. In a dual-phase immersion thermal management system, the heated dielectric cooling fluid converts to gas and evaporates. Gas travels toward the top of the tank toward a cold-water condenser that converts the gas back into a liquid, which then drips back into the tank. While such immersion thermal management systems aid in cooling and thermally managing prior IT equipment, enhancements are needed.

### BRIEF SUMMARY

According to an aspect of the disclosure, an information technology (IT) cage for immersion liquid cooling includes a cage housing, IT equipment housed within the primary internal passageway of the cage housing, and a localized cooling sub-system. The cage housing has an inflow end and an outflow end. The cage housing defines a primary internal passageway configured to allow a passive bulk flow of a cooling fluid from the inflow end to the outflow end. The IT equipment is housed within the primary internal passageway of the cage housing. The IT equipment comprises at least one primary heat-generating component and at least one secondary component positioned downstream of the at least one primary heat-generating component relative to the passive bulk flow. The localized cooling sub-system may be coupled to the cage housing. The localized cooling sub-system may further comprise a targeted cooling device configured to draw a secondary flow of the cooling fluid from an exterior of the cage housing. The localized cooling sub-system may be oriented to direct the secondary flow of the cooling fluid toward the at least one secondary component to bypass the passive bulk flow heated by the at least one primary heat-generating component.

According to another aspect of the disclosure, a system for cooling information technology (IT) equipment comprises an immersion cooling unit, at least one IT cage, a cage housing, IT equipment, and a localized cooling sub-system. The immersion cooling unit may comprise a tank enclosure that has an interior space containing a volume of a cooling fluid. At least one IT cage may be positioned within the interior space and at least partially submerged in the cooling fluid. The at least one IT cage comprises a cage housing having an inflow end and an outflow end. The cage housing defines a vertical passageway for a primary upward bulk flow of the cooling fluid. The IT equipment may be housed within the cage housing and comprise a primary heat-generating component and a secondary downstream component positioned closer to the outflow end than the primary heat-generating component. The localized cooling sub-system coupled to the at least one IT cage. The localized cooling sub-system may comprise a targeted cooling device configured to draw a localized portion of the cooling fluid from the interior space exterior to the cage housing. The localized cooling sub-system may be configured to inject the localized portion of the cooling fluid directly toward the secondary downstream component to bypass the primary upward bulk flow heated by the primary heat-generating component.

According to aspects of the disclosure, improved immersion cooling unit systems are disclosed to improve overall cooling of IT equipment within the system. The new immersion tank system provides for a modified two-chamber immersion cooling unit structure, as well as improved targeted flow cooling. The modified immersion cooling unit structure and the improved targeted flow cooling can be utilized alone or in combination with one another. In some examples, these improvements can help to address increased power consumption demands of modern-day processing requirements for AI and supercomputer processing, all of which far exceed 500W of power.

According to another aspect of the disclosure, an immersion unit for immersion liquid cooling includes a tank enclosure, a first cooling chamber, a second cooling chamber, and a partition chamber wall. The tank enclosure includes an interior space configured for immersion of information technology ("IT") equipment within the tank enclosure. The first cooling chamber may include an inlet for receiving cooling fluid from a cooling fluid supply external to the tank enclosure. The second cooling chamber may have an outlet for recirculating heated cooling fluid within the second cooling chamber to the external cooling fluid supply. The heated cooling fluid may be cooling fluid from the first cooling chamber that is increased in temperature due to convention. The partition chamber wall may be positioned within the interior space. The partition chamber wall may further include a top surface and a bottom surface. The petition chamber wall may extend substantially across a length and width of the interior space. The partition chamber wall may further separate the interior space into the first cooling chamber and the second cooling chamber. In this configuration, the top surface of the partition chamber wall defines a bottom surface of the second cooling chamber and the bottom surface of the partition chamber wall defines a top surface of the first cooling chamber. The partition chamber wall may have a plurality of wall openings that extend through the top and bottom surfaces of the partition chamber wall. The partition chamber wall may be configured to receive a plurality of IT cages housing the IT equipment and that are positioned within a corresponding one of the plurality of wall openings. The partition chamber wall may be configured to allow for each of the plurality of IT cages to be positioned within the first cooling chamber and the second cooling chamber at the same time during immersion cooling.

According to another aspect of the disclosure, a system for cooling IT equipment includes an immersion unit, a cooling fluid, and a heated cooling fluid. The immersion unit of the system further includes a tank enclosure, a first cooling chamber, a second cooling chamber, and a partition chamber wall. The cooling fluid may be disposed within the first cooling chamber and has a first temperature. The heated cooling fluid within the second cooling chamber may have a second temperature greater than the first temperature. The tank enclosure of the cooling unit can further include an interior space that is configured to immerse IT equipment within the tank enclosure. The first cooling chamber may include an inlet for receiving cooling fluid from a cooling fluid supply external to the tank enclosure. The second cooling chamber may have an outlet for recirculating heated cooling fluid within the second cooling chamber to the external cooling fluid supply. The heated cooling fluid may be cooling fluid from the first cooling chamber that is increased in temperature due to convention. The partition chamber wall may be positioned within the interior space. The partition chamber wall may further include a top surface and a bottom surface. The petition chamber wall may extend substantially across a length and width of the interior space. The partition chamber wall may further separate the interior space into the first cooling chamber and the second cooling chamber. In this configuration, the top surface of the partition chamber wall defines a bottom surface of the second cooling chamber and the bottom surface of the partition chamber wall defines a top surface of the first cooling chamber. The partition chamber wall may have a plurality of wall openings that extend through the top and bottom surfaces of the partition chamber wall. The partition chamber wall may be configured to receive a plurality of IT cages housing the IT equipment and that are positioned within a corresponding one of the plurality of wall openings. The partition chamber wall may be configured to allow for each of the plurality of IT cages to be positioned within the first cooling chamber and the second cooling chamber at the same time during immersion cooling.

According to another aspect of the disclosure, a system for cooling information technology ("IT") equipment includes an immersion unit, a cooling fluid, a heated cooling fluid, and a plurality of IT cages. The immersion unit of the system further includes a tank enclosure, a first cooling chamber, a second cooling chamber, and a partition chamber wall. The cooling fluid may be disposed within the first cooling chamber and has a first temperature. The heated cooling fluid within the second cooling chamber may have a second temperature greater than the first temperature. Each of the plurality of IT cages of the system can further include a cage housing that has an inflow end and an outflow end. The cage housing may further include a front panel, a rear panel, and opposed side panels that extend between the front and rear panels. The front, rear, and opposed side panels can further define a passageway that extends through an interior space formed by the front, rear, and opposed side panels and between the inflow end and the outflow end. The IT equipment may include at least one high-performance chip coupled to the rear panel of the cage housing. Each of the plurality of IT cages is immersed in cooling fluid within the first cooling chamber and the heated cooling fluid within the second cooling chamber, and wherein the cooling fluid from the first cooling chamber flows through each of the plurality of IT cages to the second cooling chamber.

According to still another aspect of the disclosure, there are provided improved cooling systems, units, and components, as well as methods of cooling, to improve overall cooling of IT equipment, such as servers and high-performance chips. Immersion cooling systems disclosed herein provide for a modified two-chamber immersion cooling unit, as well as improved targeted flow cooling. Additional immersion cooling unit systems disclose the combination of water cooling with immersion cooling using dielectric cooling fluids. Improved system components, such as chassis or cages for housing equipment with targeted cooling are also disclosed that alone or in combination with single or two-chamber immersion cooling units provide for enhanced cooling of components within the cage that are downstream of primary heated microelectronic devices.

### BRIEF DESCRIPTION OF THE DRAWINGS

FIG. 1 depicts a schematic cross-sectional view of an example immersion cooling system according to an aspect of the disclosure.
FIG. 2 illustrates a schematic top view of an example immersion cooling unit of the example immersion cooling system according to an aspect of the disclosure.
FIG. 3 is a schematic cross-sectional view taken across line 3-3 of FIG. 2.
FIG. 4 is a schematic cross-sectional view of a partition wall in a first configuration according to an aspect of the disclosure.
FIG. 5 is a schematic cross-sectional view of a partition wall in a second configuration according to an aspect of the disclosure.
FIG. 6 is a schematic view of a cage according to an aspect of the disclosure.
FIG. 7 is a cross-sectional schematic view taken along line 7-7 of FIG. 6.
FIG. 8A is a schematic cross-sectional view of the system taken along line 8-8 of FIG. 1.
FIG. 8B is another example schematic cross-sectional view of the system taken along line 8-8 of FIG. 1.
FIG. 9 depicts a schematic cross-sectional view of another example immersion cooling system according to an aspect of the disclosure.
FIG. 10 is a schematic cross-sectional view of the system taken along line 10-10 of FIG. 9.
FIG. 11 is an example control system according to an aspect of the disclosure.
FIG. 12A is a flow diagram of a method for controlling targeted fluid flow.
FIG. 12B is another schematic cross-sectional view of the system taken along line 10-10 of FIG. 9.
FIG. 13A is another schematic cross-sectional view of the system taken along line 10-10 of FIG. 9.
FIG. 13B is another schematic cross-sectional view of the system taken along line 10-10 of FIG. 9.
FIG. 14 depicts a schematic cross-sectional view of another example immersion cooling system according to an aspect of the disclosure.
FIG. 15 is a schematic cross-sectional view of the system taken along line 15-15 of FIG. 14.
FIG. 16 is another schematic cross-sectional view of a cooling system with an example cage therein.

### DETAILED DESCRIPTION

Immersion thermal management systems, units, and methods are disclosed that improve immersion cooling of computer components, including, without limitation, servers, motherboards, power modules, HPC chips, AI chips, memory cards, SDS cards, and various other computing components or equipment ("IT equipment"). Prior immersion thermal management systems have typically been used to provide efficient cooling for processing units or chips consuming 500W of power and below. However, improvements are needed to address increased power consumption demands of modern-day processors and processing chips whose power consumption far exceed 500W of power, and today exceeds 1000W of power. Similarly, the maximum temperature at which to maintain cooling fluid within an immersion cooling system is typically determined to be the highest temperature at which the IT equipment can reliably operate. Average operating temperatures for IT equipment typically fall within a temperature range of 15°C to 105°C, with high-power consumption IT equipment operating at the higher end of the temperature range. For example, CPUs and GPUs typically operate at 65°C to 90°C. In some examples, the improved systems, units, and methods can help to ensure that IT equipment is operating well below the maximum required temperature.

An improved thermal management system according to aspects of the disclosure can include an improved thermal immersion unit. The thermal immersion unit may include a first cooling chamber, a second cooling chamber, and a partition chamber wall disposed between the first and second cooling chambers. The partition chamber wall can include openings that are configured to receive IT cages or chassis that house IT equipment, including servers and/or high-power processing chips. The partition chamber wall segregates cooling fluid in the first cooling chamber from heated cooling fluid in the second cooling chamber. The IT equipment may be positioned within both the first cooling chamber and the second cooling chamber to enhance overall cooling of the IT equipment. For example, the IT equipment, which may be housed in an IT cage, may be partially positioned with first cooling chamber and partially positioned within second cooling chamber. A majority of the IT cage and/or IT equipment may be positioned within the first cooling chamber to increase the volume of cooling liquid that extends around the IT cage. As heat from the IT equipment in the first cooling chamber is transferred to cooling fluid flowing over and/or through the IT equipment, the now heated cooling fluid flows to the second cooling chamber so as to be segregated from the cooling fluid in the first cooling chamber, which will be at a temperature that is less than the temperature of the heated cooling fluid from the first cooling chamber. The partition chamber wall segregates heated cooling fluid in the second cooling chamber from cooling fluid in the first cooling chamber to create a greater temperature difference between cooling fluid in the first cooling chamber and the heated cooling fluid in the second cooling chamber.

Optionally, secondary spot or targeted cooling of components within the immersion cooling system can also be implemented. For example, a closed or open loop of secondary cooling fluid can be provided directly to specific IT equipment housed within each of the IT cages. In another example, additionally or alternatively, a cooling structure may be provided as part of or coupled to the IT cage. In some examples, the position of the cooling structure along the IT cage may be closer to the bottom surface of the partition chamber wall. The cooling structure may be a device that is configured to draw cooling fluid in the first cooling chamber that extends around a periphery of IT cage into the IT cage. The cooling structure, such as, but not limited to a rotating fan, may intake cooling fluid from first cooling chamber into the IT cage. The position of the cooling structure closer to the partition chamber wall draws in cooling fluid to cool down components that are downstream of cooling fluid that has already been heated due to the transfer of heat from other IT equipment in the cage.

Alternatively, secondary spot or targeted cooling can b0e implemented with a thermal immersion unit that does not include two segregated chambers, and is instead a traditional thermal immersion unit that includes a tank with a single chamber. IT cages would be provided and/or supported within the single chamber. For example, a closed or open loop of secondary cooling fluid can be provided directly to specific IT equipment housed within each of the IT cages within the single chamber. In another example, additionally or alternatively, a cooling structure may be provided as part of or coupled to the IT cage that is supported within the single chamber. The cooling structure may be a device that is configured to draw cooling fluid from outside of the IT cage and that extends around a periphery of IT cage into the IT cage within the single cooling chamber. The cooling structure, such as, but not limited to a rotating fan, may intake cooling fluid from the single cooling chamber into the IT cage. The position of the cooling structure closer to outflow end of the IT cage can help to draw in cooling fluid to cool down components that are downstream of cooling fluid that has already been heated due to the transfer of heat from other IT equipment in the cage.

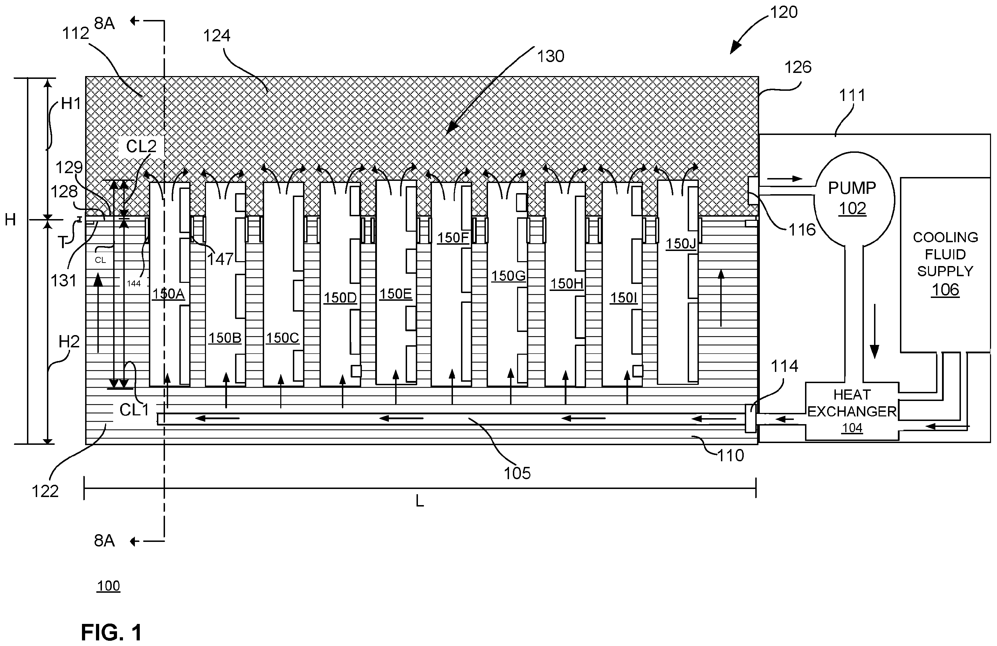

FIG. 1 illustrates an example single phase cooling system according to an aspect of the disclosure. Cooling system 100 may include a pump 102, a heat exchanger 104, a cooling fluid supply 106, and an immersion cooling unit 120. Immersion cooling unit 120 may further include server trays or in this example chassis or cages 150A-150J (collectively "cages 150") that house and protect various IT equipment. In this example, immersion cooling unit 120 is configured to support ten cages, but in other examples, immersion cooling unit 120 can be configured to support and cool any number of desired cages. Immersion cooling unit 120 includes two internal chambers - first cooling chamber 122 and second cooling chamber 124 - that are physically segregated from one another and configured to contain cooling fluids into which cages 150A-150J will be immersed. Cooling fluid, such as dielectric cooling fluid 110 that is fed from cooling fluid supply 106 and heat exchanger 104 is primarily contained within first cooling chamber 122. Second cooling chamber 124 contains heated cooling fluid from first cooling chamber 122 that flows up through respective cages 150A-150J and into second cooling chamber 124 through openings in partition chamber wall 128. Heated dielectric fluid 112 may then be pumped out of second cooling chamber 124 by pump 102 to heat exchanger 104, which recirculates cooled fluid back into first cooling chamber 122. To further enhance cooling, cages 150A-150J may include additional targeted flow features, such as a cage flow mechanism that is configured to provide a local and directed cooling fluid flow to IT equipment downstream of components within the cage and to facilitate movement of cooling fluid from first cooling chamber 122 to second cooling chamber 124.

FIG. 1 further illustrates an example immersion cooling tank or immersion cooling unit 120. Immersion cooling unit 120 includes an immersion tank enclosure or housing 126 that encloses an interior space 130. At least a portion of interior space 130 is further defined by partition chamber wall 128 that segregates a first cooling chamber 122 and second heated cooling chamber 124. First cooling chamber 122 may be filled with and contain a cooling fluid 110, such as a dielectric cooling fluid that is fed directly from cooling fluid supply 106 and heat exchanger 104. Cooling fluid 110 in first cooling chamber 122 is illustrated with horizontal hatching. Second cooling chamber 124 houses heated cooling fluid 112 that flows up through respective cages 150A-150J and into second cooling chamber 124. Segregated cooling fluid 112 is heating cooling fluid and represented by cross-hatching. Immersion cooling unit 120 will generally have a length L and a height H extending along a perpendicular vertical plane, which can be accordingly sized to meet any desired specification and to hold any number of cages.

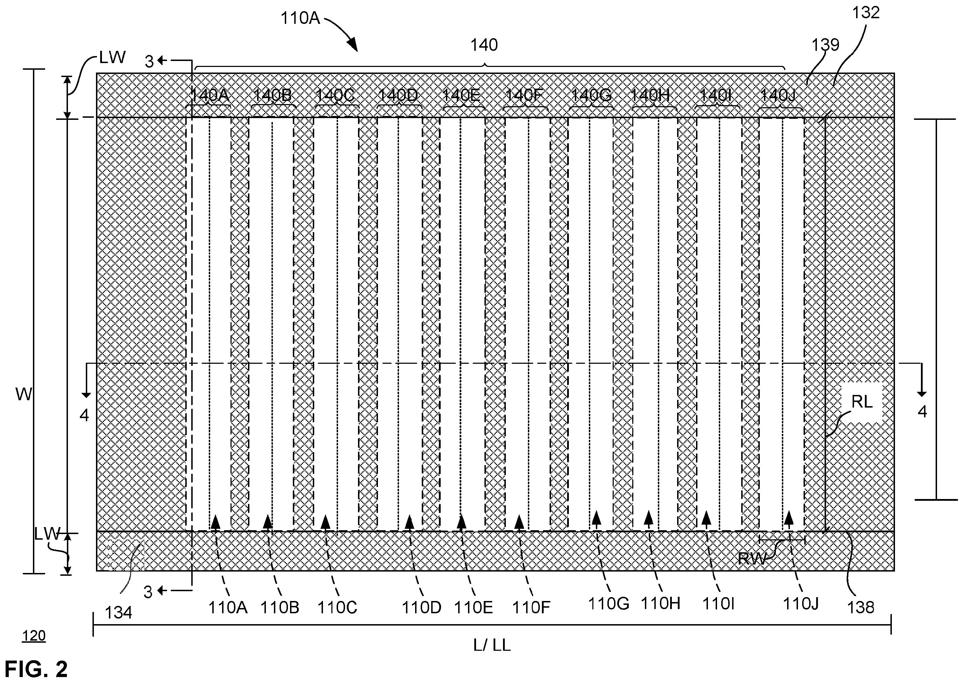

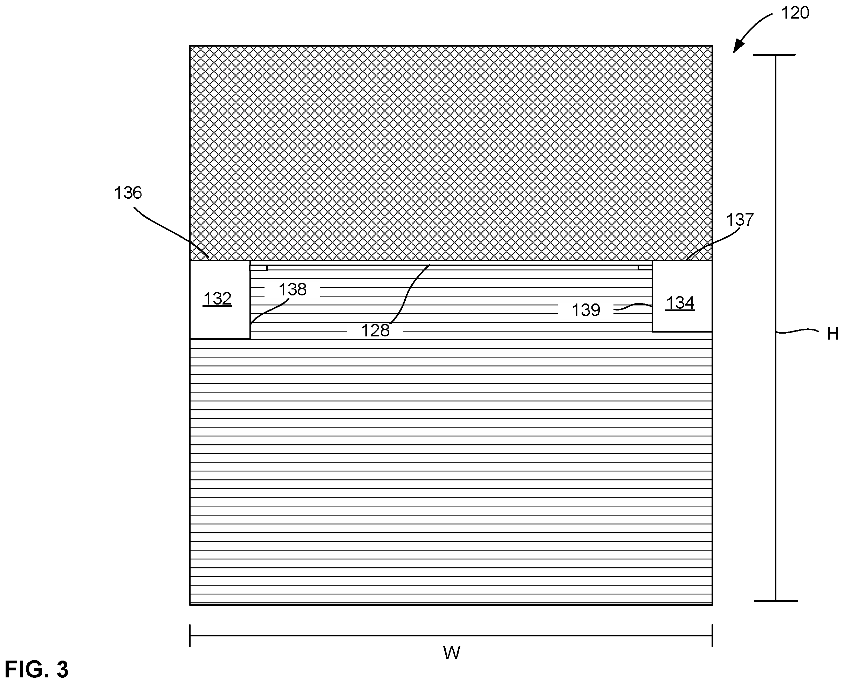

FIG. 2 illustrates a top view of immersion cooling unit 120 standing alone and without cages 150A-150J positioned within immersion cooling unit 120. FIG. 3 illustrates a cross-sectional view taken along width W of immersion cooling unit 120. Immersion cooling unit 120 may optionally include respective elongated first and second ledges 132, 134 that have a ledge length LL that extends along length L of immersion cooling unit 120. In this example, ledge length LL extends along the entire length L of immersion cooling unit 120, such that ledge length LL and length L are the same, but in other examples, they may differ. Ledges 132, 134 further include ledge width LW that extends along width W of immersion cooling unit 120. Ledges 132, 134 may have respective top surfaces 136, 137 and interior edges 138, 139 extending in a direction along at least a portion of height H of immersion cooling unit 120. Ledges 132, 134 can be used to support cages 150A-150J when cages 150A-150J are inserted into openings 110A-110J within partition chamber wall 128. As shown in FIG. 1, an ancillary control cabinet 111 may optionally be provided to house controllers, user interface devices, pumps, tubing, or other hardware associated with immersion cooling system 100 that need not be contained within immersion cooling unit 120 or that may be desired to be kept readily accessible and external to immersion cooling system 100. Immersion cooling unit 120 may additionally include numerous other components to facilitate cooling, such as electronic wiring, power outlets, power sources, hoses, and other components that are not illustrated or discussed since they are not the focus of the disclosed embodiments and would be known and understood to be necessary for operation of cooling system by one skilled in the art.

With reference back to FIG. 1, partition chamber wall 128 is positioned between first and second cooling chambers 122, 124. The free flow of cooling fluid between first and second cooling chambers 122, 124 is inhibited by partition chamber wall 128, which provides a physical barrier between first and second cooling chambers 122, 124 so as to allow for segregation between the majority of cooling fluid 110 in first cooling chamber 122 and heated cooling fluid 112 in second cooling chamber 124.

The partition chamber wall (128) can provide thermal and fluidic isolation that provides for decoupling of the pressure environments that may be created in the first chamber (122) and the second chamber. Local pressure differentials may be created due to the high-velocity intake of the IT equipment within the cage and/or the "bypass" of cooling fluid that flows in the around the cage, instead of flowing through the cage and the heated IT equipment and that instead. This can pull warmer, less dense fluid downward, and contaminate the cooler fluid in the first chamber The partition chamber wall (128) inhibits downward fluidic forces caused by the local pressure differentials at or between the cages, which can otherwise overcome the natural upward buoyancy of the heated fluid. By providing a physical barrier against these downward flow currents, the partition can minimize heated exhaust fluid flowing from the cages and into the second chamber from being recirculated and trapped within the first lower chamber (122). This can help to enhance cooling by maintaining the integrity of the cool fluid reservoir and ensuring a maximized temperature differential across the cage

For example, partition chamber wall 128 may possess a thickness T of any desired thickness. In some examples, thickness T may range from at least 5-12 inches. In other examples, thickness T may be less than 5 inches or greater than 12 inches. In still other examples, the thickness T may be less than 0.5 inches, such as without limitation, 0.4 inches, or greater than 1 inch. In some example, thickness T may range from 0.4-2 inches. Partition chamber wall 128 may be further configured and designed to support the weight of IT cages, such as cages 150A-150J positioned within partition chamber wall 128.

As shown in FIGS. 1 and 2, partition chamber wall 128 may be a generally planar surface that extends across a length L of interior space 130. In some examples, partition chamber wall 128 may be removably coupled to cooling chamber 122 so as to allow for easy access by an operator to the bottom of immersion cooling unit 120, and particularly to the bottom of first cooling chamber 122.

In some examples, it may be desired for some or all of the partition chamber wall 128 to be insulative so as to ensure that heat or heated fluid from second cooling chamber 124 does not further cause heating or an increase in temperature of cooling fluid 110 in first cooling chamber 122. In some examples, it may alternatively or additionally be desired to coat or provide a secondary material overlying top surface 129 of partition chamber wall 128 in order to insulate second cooling chamber 124 to maintain the temperature of heated cooling fluid 112 and to minimize any effects the increased temperature of second cooling chamber 124 would have on cooling fluid in first cooling chamber 122.

While in this examples the two chambers are thermally isolated from one another, in other examples, the material comprising partition chamber wall 128 may optionally include a thermally conductive or highly thermally conductive material to further enhance transfer of heat from dielectric cooling fluid 110 in first cooling chamber 122 to heated dielectric cooling fluid 112 in second cooling chamber 124 or additionally or alternatively to the exterior of the tank or first cooling chamber 124. In such examples, partition chamber wall 128 may be configured to further include conductive features to further draw out or transfer heat from dielectric cooling fluid 110 in first cooling chamber 122, such as conductive fins extending upwardly from top surface 129 of partition chamber wall 128 or further distributing heat outwards. Conductive features may be comprised of a thermally conductive feature, such as copper, aluminum or any desired thermally conductive material

A plurality of openings extend through a top surface 129 and bottom surface 131 of partition chamber wall 128. FIG. 2 illustrates an example perimeter and location of each opening 140A, 140B, 140C, 140D, 140E, 140F, 140G, 140H, 140I, 140J (collectively "openings 140"), which are closed in this view and therefore shown in broken lines. The opening may take on different shapes and sizes, such as elongated slots or openings that can receive one or more cages. Although heated cooling fluid 112, which is represented by cross hatching, is shown in second cooling chamber 124 adjacent the location of each of the openings 140, it is to be appreciated that heated cooling fluid 112 also overlies the area where each of the openings 140 are located when the openings are in the closed position. Cooling fluid 112 that would normally overlie the closed openings 140 in this view is omitted in this view to better illustrate the presence and location of each opening. As shown, openings 140 may have opening length RL and opening width RW that are sized and configured to receive cages, as well as allow for insertion and removal of cages within each opening.

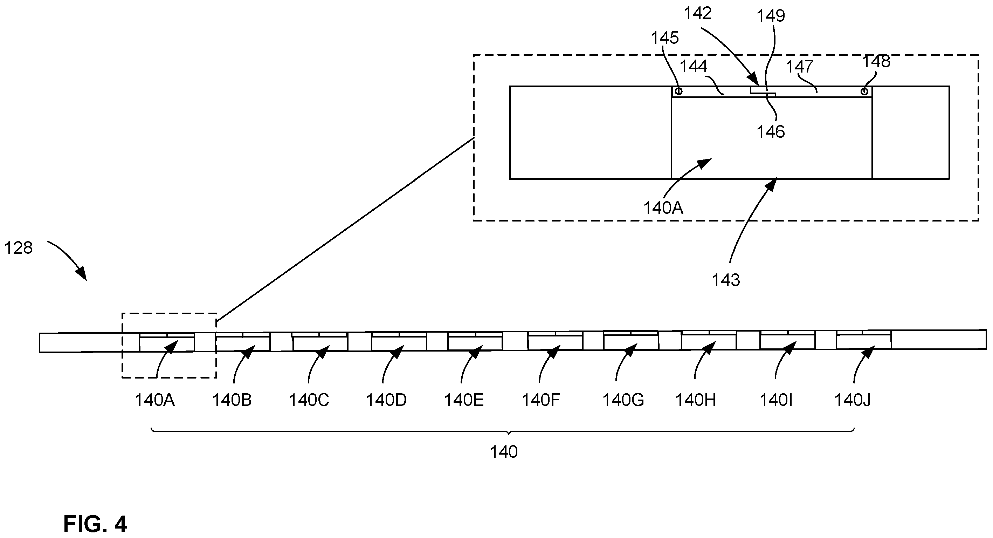

With reference to FIG. 4, a schematic cross-sectional view of partition chamber wall 128 standing alone with wall openings in the closed position, some or all of wall openings 140 within partition chamber wall 128 may include a structure that opens and closes entrance 142 to each of the wall openings 140. The structure itself may be movable, such that it can move from an open position to a closed position. In one example, one or more movable flaps or door panels may be positioned at the entrance of each wall opening 140. Such panel(s) may overlie each wall opening to inhibit or allow for dielectric cooling fluid to flow through wall openings 140. The panels can further include additional structure, such as baffles, contoured or roughened surfaces, or any feature that can help to control or manipulate the flow of cooling fluid between the first cooling chamber and the second cooling chamber.

The enlarged portion of FIG. 4 illustrates an example schematic pair of movable panels that are configured to move between an open position and a closed position. It is to be appreciated that all wall openings 140 may have a similar configuration, but for ease of discussion and illustration, only wall opening 140A is discussed. A pair of movable panels overlies entrance 142 to wall opening 140A. The movable panels include first panel 144 and second panel 147 that are configured to move between an open and closed position. The configuration shown is the closed position where first and second panels 144, 147 are positioned directly adjacent one another and block entrance 142 to wall opening 140A where cooling fluid 110 from first cooling chamber 122 may flow through wall opening 140A into second cooling chamber 124. First and second panels 144, 147 are configured to move from the first closed position to a second open position when cage 150A is inserted into and positioned within wall opening 140A. First end 145 of first panel 144 and first end 148 of second panel 147 may be rotatably coupled to partition chamber wall 128 by a mechanical fastener, such as a pin, threaded screw, or other fastener extending therethrough. In other examples, any type of mechanism to allow for opening and closing of first and second panels 144, 147 may be implemented. First and second panels 144, 147 may each rotate about their respective mechanical fastener. As shown in this example, the shape of second end 146 of first panel 144 and the shape of second end 149 of second panel 147 may be complementary so that in the closed position, first and second panels 144, 147 meet together to form a continuously planar top surface and to form a seal to inhibit flow through wall opening 140A. This can help to ensure that heated cooling fluid 112 within second cooling chamber 124 remains segregated from dielectric cooling fluid 110 in first cooling chamber 122.

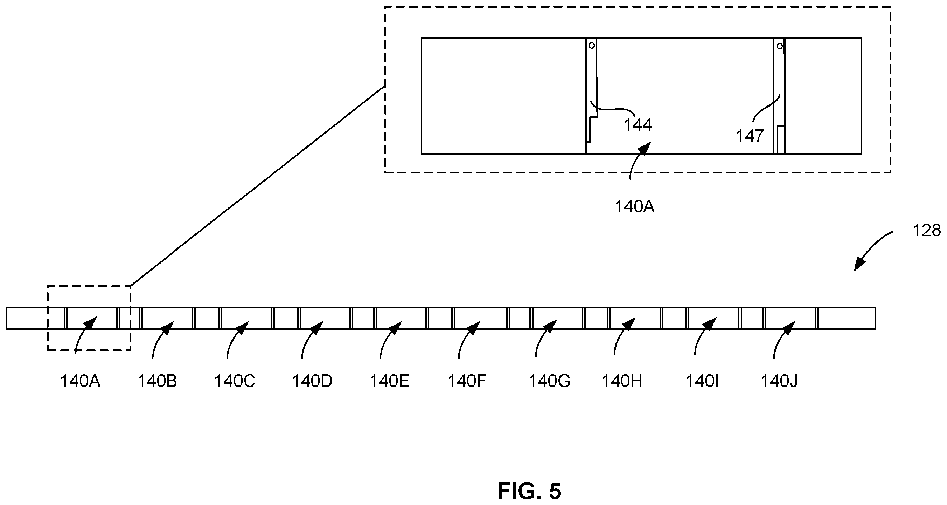

When a cage, such as cage 150A is inserted into a wall opening, such as wall opening 140A, cage 150A exerts a downward force on first and second panels 144, 147, causing first and second panels 144, 147 to rotate downwards into wall opening 150A. FIGS. 1 and 5 illustrate first and second panels 144, 147 in the open position. Additional features may be added to help ensure segregation between first and second cooling chambers 122, 124. For example, rubber gaskets and the like may be provided between first and second panels 144, 147 and/or first and second panels 144, 147 may be coated to help prevent water leakage when first and second panels 144, 147 are in the closed position.

Entrance 142 directly adjacent second cooling chamber 124 is shown in FIG. 4 as being blocked or closed off by a closing mechanism, such as first and second panels 144, 147, but entrance 143 adjacent first cooling chamber 122 is not blocked. In other examples, a closing mechanism, similar to first and second foldable panels, may instead be positioned adjacent entrance 143, such that entrance 142 remains open at all times. In still other examples, an opening-closing mechanism may be provided at both entrances 142,143 such that there are two sets of panels. In still other examples where an opening-closing mechanism is provided at both entrances 142, 143, two different types of closing mechanisms may be used.

Numerous other methods and structures can be implemented to allow for opening and closing of the wall opening. For example, instead of two panels, only one panel may be implemented that extends across an entire wall opening and that folds downward when a cage is positioned within the wall opening. In another example, a panel may instead be retractable into the thickness of partition chamber wall 128 like a pocket door. In any one of the aforementioned examples, panel(s) and/or other mechanisms implemented to physically open and close one or both entrances to each wall opening 140 may be operated by a control system. In still other examples, it may be desired to eliminate the ability to close the openings and the inclusion of panels altogether. In such examples, wall openings 140 would remain uncovered or open at all times. Convection currents would maintain the upward flow of heated cooling fluid into the second cooling chamber 124 when cages 150 are not positioned within one or more of the wall openings 140 of partition chamber wall 128.

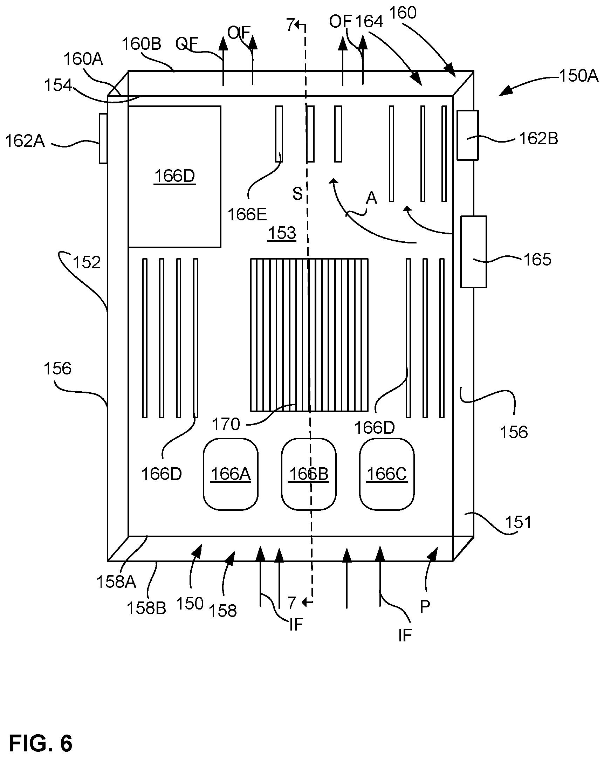

Cages 150 can house IT equipment that will be cooled within immersion cooling unit 120. As shown in FIG. 6, cages 150A may including a housing 151 that is generally in the shape of a rectangle. Cage 150A may include a base or back panel 152, a front panel 154, and opposed side panels 156. Cage 150A may further include inflow end 158 and outflow end 160, where the inflow end allows incoming cooling fluid or inflow to enter cage 150A, such as represented by arrows IF, and outflow end allows for heated cooling fluid or outflow to exit cage 150A such as in the direction indicated by arrows OF. In this example, inflow and outflow ends are open ends to facilitate the free flow of cooling fluid into and out of cage 150A. But, in other examples, some or all portions of inflow end 158 and outflow end 160 of cage 150A may be covered and/or another means of fluid flow through and out of cage 150A may be provided.

In one example, each of the panels are generally continuous major surfaces that extend between inflow end 158 and outflow end 160 of cage 150A. In other examples, the cage may have openings along one or more of front panels 154, back panel 152, or side panels 156. In still other examples, cage 150 may be a skeletal structure, such that the side panels 156 and/or front panel 154 may be omitted altogether. Inflow end 158 and outflow end 160 may be substantially open ends. For example, inflow opening 161 is defined at inflow end 158 of cage housing 151 in the interior space between front panel 154, back panel 152 and side panels 156, and more particularly between opposed inflow edges 158A, 158B of inflow end 158 and interior edges of side panels 156. Outflow opening 164 is defined at outflow end 160 in the interior space between opposed outflow edges 160A, 160B and opposed side surfaces 156. A passageway P is defined by an interior space formed by back panel 152, front panel 154, and opposed side panels 156 and extends between inflow end 158 and outflow end 160.

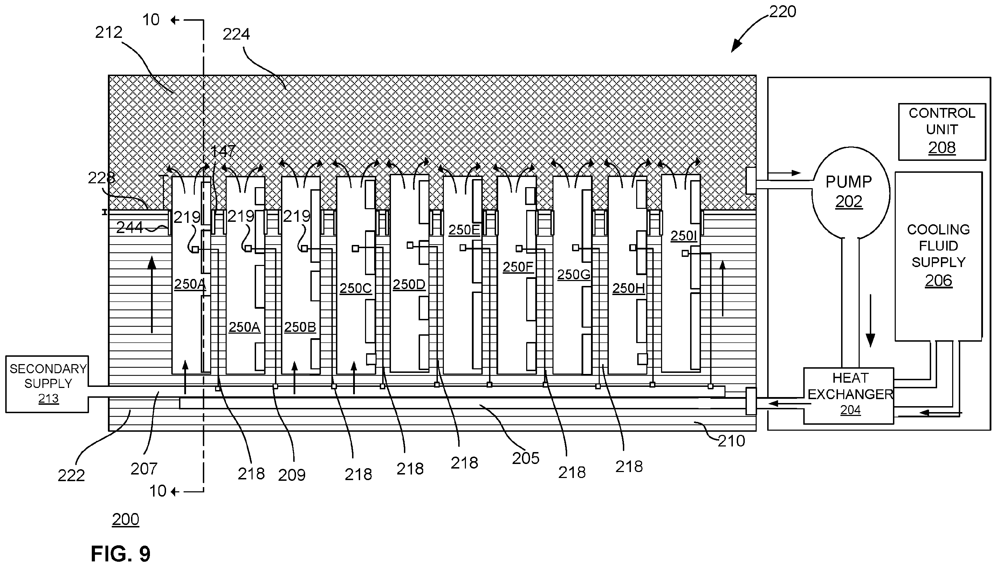

Each cage, such as cage 150A, may further include cage supports 162 that extend outwardly from side surfaces 156 and which secure cage 150A within partition wall 128. Additionally, as will be described in more detail in at least FIGS. 9-14, one or more local fluid flow mechanisms may be included within or adjacent cage 150A so as to provide localized or targeted cooling of IT equipment within cage 150A from a local cooling fluid source. Although the discussion of the structure of cages 150 is focused on cage 150A, it is to be appreciated that all of the cages may have a similar configuration and are not further discussed. In still other examples, cages 150 can take on various shapes and configurations that are configured to meet certain specifications or applications and the cages 150 may also differ from one another.

Cage 150A may be used to house various IT equipment. In some examples, cage 150A may be a server with a server tray and computing components thereon. But various applications and configurations which require cooling of IT equipment can be implemented. A printed circuit board ("PCB") may be positioned adjacent back panel 152 and within passageway P. IT equipment may be mounted or bonded to the PCB. As previously discussed, IT equipment can include high-power consumption chip packages, processors, such as CPUs, GPUs, TPUs, power modules, memory, and various other components.

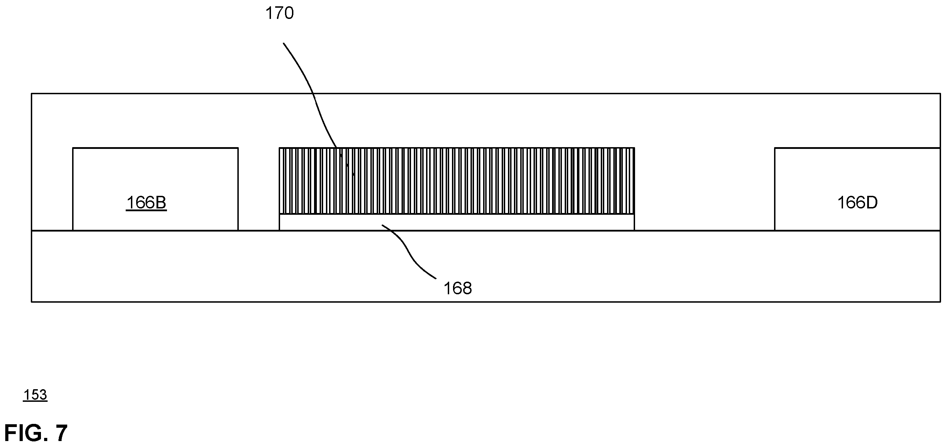

With reference still to FIG. 6, an example high-level schematic arrangement of example IT equipment on a PCB 153 is depicted, but it is to be appreciated that any arrangement and other IT equipment illustrated or not illustrated can be implemented according to aspects of the disclosure. In this example, IT solid state devices ("SSDs") 166A, I/O device 166B, network cards 166C may be positioned adjacent inflow end 158. Dual in-line memory modules ("DIMMs") 166D may be positioned further downstream and towards the central portion of PCB 153. A power module 166E and DIMM 166E may be positioned further downstream toward outflow end 160. As also shown in FIG. 7, at least one high-power computing component may be bonded to PCB 153. For example, one or more microelectronic devices or elements 168, such as high-power semiconductor chips or processors (also chip or one or more chips 168), may be arranged towards a center of PCB 153 or on any portion of PCB 153. Such microelectronic elements 168 may generate significant heat and are otherwise primary heat-generating components within the cages. Additional cooling features, such as cold plate 170, may overlie chip 168. Additional cooling features may also be implemented, such as a separate containment unit provided directly around processor 168 and cold plate 170. Power module166E and DIMMs 166E are positioned downstream of chip package 168, with DIMMs 166E being positioned directly downstream in the path of heated cooling fluid that flows through cage 150E and in this example, through cold plate 170. In other examples, any additional alternative components may be positioned downstream.

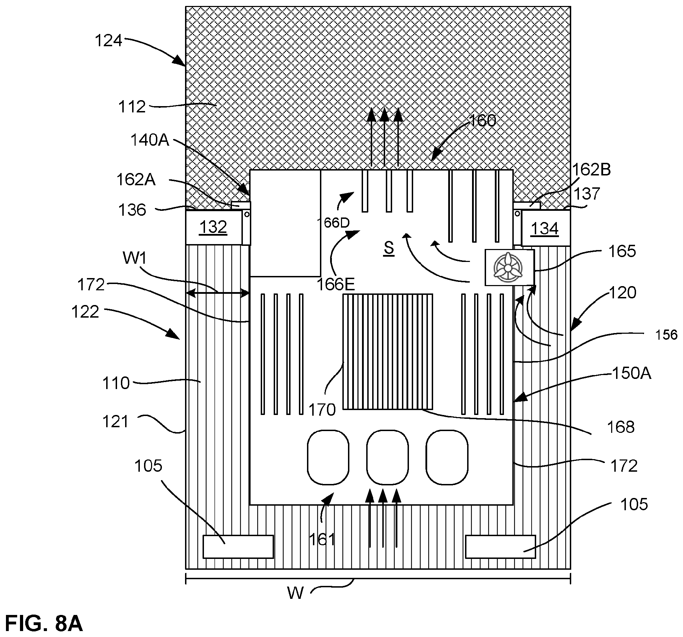

FIG. 8A illustrates cage 150A positioned within wall opening 140A. In this example, cage 150A is configured to extend across a majority of the width W of immersion cooling unit 120. Peripheral edges 172 will be spaced apart from side wall 121 of first cooling chamber 122 by a distance W1. As shown, cage 150A is positioned between ledges 132, 134. Cage supports 162A, 162B engage top surface 136 of ledge 132 and top surface 137 of ledge 134. In this example, cage supports 162A, 162B are outward and non-movable protrusions that extend outwardly from side surfaces of cage 150A, but in other examples, more sophisticated cage supports can be implemented. For example, cage supports 162A, 162B may include movable arms that can extend to an open and expanded position, in which cage supports 162 overlie ledges 132, 134, as well as a closed position when cage 150A is not in use or outside of immersion cooling unit 120. In still other examples, in addition to cage supports 162A, 162B or in lieu of cage supports 162A, 162B, a bracket, a basket, or other structure may be coupled to or formed in connection with each recess to support cage 150A so that a substantial portion of cage 150A can be positioned within first cooling chamber 122 and a smaller portion of cage 150A can be positioned within second cooling chamber 124.

Another aspect of the disclosure focuses on cooling IT equipment that is positioned adjacent outflow ends of the cages and downstream of heated components within IT cage. For example, with reference back to cage 150A, by the time cooling fluid 110 reaches downstream DIMM 166E, heat from chip 168 has been transferred to cooling fluid 110 that has passed through and/or around chip 168. As a result, as cooling fluid 110 passes across space S and reaches DIMM 166E, cooling fluid 110 is at a heightened temperature and the cooling effect of cooling fluid 110 is significantly reduced, as compared to when cooling fluid 110 entered cage 150A.

A localized cooling sub-system may optionally be implemented within one or more of the cages 150 to provide a secondary flow of downstream cooling fluid into the respective cages. One or more targeted cooling devices may optionally be provided to enhance cooling of components within cage 150A, including components downstream of chips 160. Local cooling mechanism or a targeted cooling device 165 may be provided to draw or pull in local cooling fluid 110 from first cooling chamber 122 into cage 150A. In this example, cooling fluid 110 directly adjacent the housing of cage 150A may be drawn into cage 150A. For example, cooling fluid can be drawn into cage by cooling device 165 in the direction of arrows A.

Targeted cooling device 165 may be any structure and/or device that is configured to draw cooling fluid 110 into housing 151 of cage 150A. In one example, targeted cooling device 165 may be positioned along right side surface 156 of cage housing 151 downstream of inflow opening 161. The targeted cooling device 165 may also be configured and oriented to direct this secondary flow of cooling fluid toward downstream components to deliberately bypass the passive bulk flow that has already been heated by the upstream primary components. In this example, the upstream components can include, for example, chip 168 and cold plate 170 and the downstream components can include, for example, DIMMs 166E or power modules or any other downstream components, including those adjacent an outflow edge of the cage 150A.

Targeted cooling device may be or include, for example, a pump that directs cooling fluid 110 to rear of cage housing 151 and elements that are closest to outflow end 160, which in this example are elements 166E. For example, as shown, targeting cooling device 165 comprises a housing and a pump that is coupled to the cage housing. Various types of pumps may be implemented, such as but not limited to a submersible centrifugal pump. In other examples, targeted cooling device may include a propellor or a fan, such as a high velocity fan, that is coupled to the cage 150A and directs cooling fluid 110 to rear of cage housing 151 and elements that are closest to outflow end 160.

The targeted cooling device 165 may further utilize a duct, vent, internal dedicated line, or specific housing alignment configured to inject the secondary flow at a trajectory and in some examples, at a higher pressure than a pressure of the passive bulk flow. This avoids an upstream primary heat-generating component, thereby delivering unheated fluid directly to the secondary components toward the rear of the cage 150A. In this example, the secondary components are positioned at a higher vertical height than the primary heat-generating components, such as the one or more chips 168. The secondary flow subsequently merges with the heated passive bulk flow and exits the outflow end 160 into the second cooling chamber 124. This configuration can actively cool downstream elements without requiring complex internal piping manifolds.

As shown, targeted cooling device 165 can draw cooling fluid from the immersion unit into the cage 150A at a position that is downstream of the chip 168. The cooling fluid is drawn from cooling fluid exterior to cage 150A and directly adjacent and surrounding cage150A. This allows for a fresh supply of cooling fluid at a point downstream of the chips 168, which in this example, is a secondary supply of cooling fluid than the bulk fluid flowing though the cage 150A or being directly fed from a cooling fluid supply manifold. This allows components downstream of chip 168 to receive directed spot cooling from a fluid source that surrounds the cage and to receive secondary stream of fluid that will be at a temperature that is cooler than the temperature of fluid flowing through the cage and downstream of the chips 160.

In examples where the cage 150A is positioned within a dual chamber immersion unit, the targeted cooling device 165 is positioned within the first cooling chamber and at a point below the chamber wall, such that cooling fluid segregated from the second cooling chamber is drawn into the cage 150A. This provides for the direct introduction of cooling fluid within cage 150 to downstream components, as opposed to fluid that flows through the cage and that may be heated by the time it reaches the downstream components and/or cooling fluid that may be connected to or coupled to another manifold that feeds directly to any downstream components. Further, with the presence of the partition chamber wall 128 isolating the first and second cooling chambers 122, 124, the cooling fluid in first cooling chamber 122 may be at a temperature that is cooler than typically available for a fooling fluid in a single chamber cooling unit. This allows for an additional cooling fluid flow to enhance cooling of downstream components at the outlet end of cage 150A. Elements closest to outflow end 160 will therefore be positioned within a portion of cage 150A that is within the second cooling chamber, such that the secondary flow will initially flow into a portion of cage 150A within the first cooling chamber 122 and exit cage 150A from a portion of cage 150A that is in the second cooling chamber 124. In this example, no additional lines or piping is required to direct or regulate the flow of cooling fluid into cage 150A, when targeted cooling device 165 draws in cooling fluid exterior to cage 150A from within first cooling chamber 122 and/or extending around the periphery of the housing of cage 150A. But, in other examples to be described herein, it may be desired to include additional connections and/or piping to provide for greater control over fluid flow positioned adjacent targeted cooling device 165 from entering adjacent external to the cage.

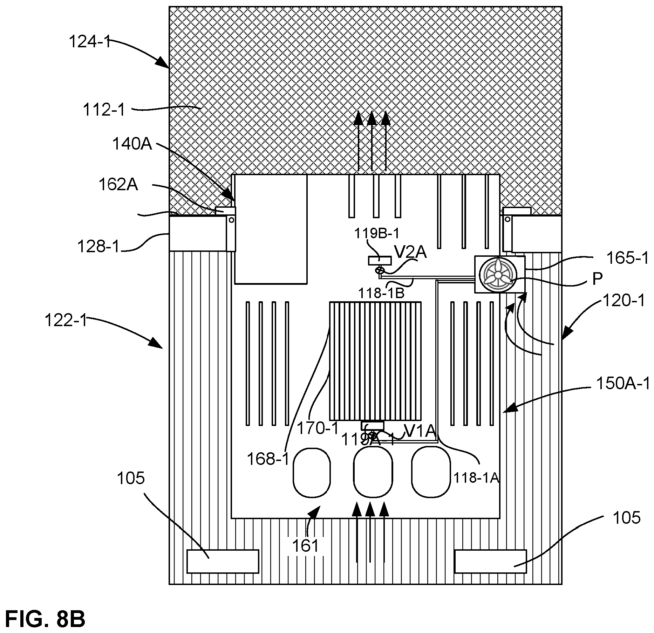

In use, with reference back to FIG. 1, cooling fluid 110 is pumped into immersion tank 120 from heat exchanger 104 through inlet 114 and into supply manifold 105. Cooling fluid 110 flows upward into immersion unit 120 from supply manifold 105 and provides a continuous supply of cooling fluid 110 to fill immersion unit 120. With reference also to FIG. 8, cooling fluid 110 flows through inflow opening 161 of cage 150A, as well as around outer peripheral edge 172 of cage housing 151. As cooling fluid 110 flows over components, cooling fluid 110 becomes heated and increases in temperature. Chips 168 can generate significant amounts of heat due to required power consumption required of high performance chips, including AI chips, such as 1000W or more. Cooling fluid passes through and around cold plates 170 and chips 168. As cooling fluid flows over cold plates 170, cooling fluid 110 becomes heated and increases in temperature as heat from chip 168 and cold plates 170 is transferred to cooling fluid 110. Cooling fluid 110 continues to flow upward across space S and through and around downstream DIMM166E. Cooling fluid 110, which is now heated, continues to flow through outflow end 160 of cage 150A and into second cooling chamber 124, where it is the now heated cooling fluid 112 contained within second cooling chamber 124. Heated cooling fluid from second chamber exits immersion unit 120 through outlet 116 and in some examples may be pumped out of immersion unit by pump 102.

The maximum temperature at which cooling fluid 110 and heated cooling fluid 112 within immersion cooling unit 120 can reach will be determined to be the highest temperature at which the IT equipment can reliably operate. According to aspects of the disclosure, it may be desired to maintain an average operating temperature that is well below the maximum temperature. For example, with average operating temperatures falling within a temperature range of 15°C to 75°C, with high-power consumption IT equipment often having a maximum operation temperature towards the higher end of the temperature range.

Implementing a partition chamber wall within system 100 to segregate cooling fluid 110 in first cooling chamber 122 and heated cooling fluid 112 in second cooling chamber 124 can help to improve and maximize the amount and temperature of cooling fluid 110 in first cooling chamber 122 that cools cages 150 and IT equipment within cages 150. As compared to prior immersion units and systems, an immersion unit according to aspects of the disclosure minimizes intermingling of cooling fluid 110 and heated cooling fluid 112 in order to create a greater difference in temperature between cooling fluid 110 in first cooling chamber 122 and heated cooling fluid 112 in second cooling chamber 124. In one example, the temperature difference may be determined by the formula Δt =T2 - T1, where T1 is the temperature of cooling fluid in first cooling chamber 122 and T2 is the temperature of cooling fluid in second cooling chamber 124. In other examples, additional factors can be taken into consideration to calculate the temperature difference Δt.

The greater difference in temperature Δt that can be achieved according to certain aspects of the disclosure can result in the maintenance of a lower temperature T1 of cooling fluid 110 in first cooling chamber 122 during operation than previously available when cooling fluid 110 and heated cooling fluid 112 were intermingled to form a homogenous immersion fluid. In some examples, Δt may range from 5°C to 15°C or range from 5°C to 10°, but in other examples, Δt may be less than 5°C or greater than15°C or greater than 10°. In some examples, Δt may be at least 6°C. In other examples, temperature difference Δt ranges from 4°C to 8°C. In other examples, temperature difference Δt is greater than 5°C. In still other examples, the temperature T1 of the cooling fluid in the first cooling chamber is at least 40°C or at least 60°C. It is to be appreciated that aspects of the disclosure allow for temperature difference Δt to be maintained over a sustained period of time and preferably throughout operation of the cooling fluid when cooling high performance computing components or those components requiring high power consumption. For example, any desired temperature difference Δt can be selected and maintained for a set period of time, such as at least 30 minutes, or 40 minutes, or 1 hour or 24 hours. Similarly, a desired temperature TC can be maintained in first cooling chamber 122 over a sustained period of time and preferably throughout operation of the cooling fluid when cooling high performance computing components or those components requiring high power consumption. For example, any desired sustained temperature TC can be selected and maintained for a set period of time, such as at least 30 minutes, or 40 minutes, or 1 hour or 24 hours.

The position of cages 150 in both first cooling chamber 122 and second cooling chamber 124 can further enhance cooling of IT equipment. The ability to position cages 150 within both first and second cooling chambers 122, 124 provides for greater flexibility in determining the amount of cooling fluid 110 that directly contacts the outer surface area of housing 151 of cages 150, which can further improve overall cooling of cages 150 and the IT equipment therein. This can also be beneficial when cooling fluid 110 can be maintained at reduced temperatures due to the segregation of cooling fluid 110 and heated cooling fluid 112. In other examples, as described herein, the immersion tank does not include first and second cooling chambers and the cages 150 can be fully immersed within a single chamber unit or tank, such that it is unnecessary to determine the difference in temperature between first and second chambers and instead a difference in temperature of the cooling fluid may be determined based on other parameters, such as temperature differences at different levels with the immersion chamber unit, at different times, or any other desired parameter.

With reference back to FIGS. 1 and 8, a majority of overall cage length CL of cages 150 may be positioned within first cooling chamber 122 to achieve optimal cooling. For example, a length CL1 of cages 150 positioned within first cooling chamber 122 will be exposed to cooling fluid 110. A length CL2 of cages 150 positioned within second cooling chamber 124 will be exposed to heated cooling fluid 112 in second cooling chamber 124. Lengths CL1 and CL2 can be adjusted to achieve optimal cooling by moving the cages 150 further into or further out of first cooling chamber 122. In some examples, length CL1 will be greater than length CL2. In some examples, length CL1 is 75% of overall cage length CL and CL2 is 25% of overall cage length CL. In other examples, length CL1 may be 80% of overall cage length CL and CL2 is 20% of overall cage length CL. In still other examples, length CL1 may be 90% of overall cage length CL and CL2 is 10% of overall cage length CL. In still other examples, length CL1 may be greater than 70% of overall cage length CL.

As noted above, targeted cooling device 165 can optionally be implemented to improve cooling of components downstream of the chip or other heated components. This fresh supply of cooling fluid can be provided without a dedicated line or direct connection to or a piping feed from the same or other manifolds in the cooling unit. In some examples, this can lead to a further increase in the difference in temperature between the temperature of cooling liquid 110 in first cooling chamber 122 and the temperature of heated cooling liquid 112 in second cooling chamber 124. It can also simplify the cooling process and cooling system since additional internal hoses and a secondary manifold within cage 150A or directly adjacent cage 150A are not required to provide local spot cooling of internal components within cage 150A.

In other examples, certain applications may benefit from the inclusion of enhanced targeted cooling by implementing internal dedicated lines or fluid lines within one or more cages 150 that can more accurately direct cooling fluid to a certain locations. FIG. 8B illustrates one example of a cage 150A-1 that is identical to cage 150A, but further includes additional lines 118-1, such as pipes or hoses, positioned within cage 150A-1 and that are configured to direct or inject cooling fluid drawn in by targeted cooling device 165-1 from the immersion unit 120-1 into cage 150A-1.

In this example, immersion unit 120-1 is a dual chamber cooling tank having a first cooling chamber 122-1 and a second cooling chamber 124-1, but in other examples, including but not limited to those described herein, immersion unit 120-1 may be a single chamber immersion tank. Targeted cooling device 165-1 is shown positioned within the immersion cooling unit 120-1 in the first cooling chamber 122-1, which is positioned on one side of partition chamber wall 128-1 and in this example, below the partition chamber wall 128-1. Targeted cooling device 165-1 may be further positioned at a portion of the cage 150A-1 that is downstream of one or more microelectronics elements 168-1, but in other examples, the targeted cooling device 165-1 can be positioned at other points of cage 150-1, such as toward the bottom portion, the left side portion, or any other portion of cage, since hoses will be coupled to targeted cooling device 165-1 and capable of directed target fluid toward portions of the cage that re downstream of the heated fluid and microelectronic element 168-1. The position of targeted cooling device 165-1 within immersion cooling tank allows for the drawing in of cooling fluid from a fluid source that is directly adjacent cage 150A.

As shown, a first line 118-1A couples local cooling component 165-1 to a first fluid distribution element 119A-1, such as a nozzle, positioned in front of or upstream of the one or more microelectronic elements, 168-1, such as one or more semiconductor chips, which in this example are further positioned adjacent cold plate 170-1. A first valve V1A may be positioned along the first hose 118-1 to control the amount of cooling fluid distributed through the fluid distribution element 119-1. A second line 118-1B couples local cooling component 165-1 to a second fluid distribution element 119-1 positioned downstream of the one or more microelectronic elements 168-1. A second valve V2A may be positioned along the second line 118-1 to control the amount of cooling fluid distributed through second fluid distribution element,119B-1. The inclusion of first and second line 118A-1, 118B-1, first and second valves V1A, V1B, and first and second fluid distribution elements 119A-1, 119B-1 allows for more accurate targeted cooling of downstream components.

Various types of valves can be implemented along first and second lines 118A-1, 118B-1 and can include any conventional valve configured to regulate fluid flow. Valves can include, without limitation, ball valves and check valves, such as butterfly check valves. For example, without limitation, each valve V1A, V2A may have an adjustable opening and include one or more movable walls or dampers that can increase or decrease the size of the opening. When the size of the opening of valve V1A, V2A is increased, the flow and amount of cooling fluid through valves V1A, V2A also increases. When the size of the opening of valves V1A, V2A is decreased, the flow and amount of cooling fluid through respective valves V1A,V2A also decreases. Valves V1A, V2A can also be remotely and automatically monitored and controlled, as will be discussed in further detail herein.

Targeted cooling device 165-1 is shown positioned within the immersion cooling tank in the first cooling chamber 122-1. In one example, local cooling mechanism is positioned on one side of partition chamber wall 128-1 and in this example, below the partition chamber wall 128-1. In other examples, targeted cooling device 165-1 may be positioned elsewhere relative to cage 150A. Partition chamber wall 128-1 can help with ensuring that cooling fluid is present below partition chamber wall 128 and where targeted cooling device 165 is positioned. As previously discussed, heated fluid exiting cage 150A flows into the second cooling chamber 124. Partition chamber wall 128-1 is configured to withstand the downward force created by the heated cooling fluid in second cooling chamber that exits cages 150-1 so that heated cooling fluid is prevented from returning back to the first cooling chamber 122 and cage 150A. The position of local cooling mechanism within the first cooling chamber 122 of the immersion cooling tank allows for the drawing in of cooling fluid from a secondary fluid source that is directly adjacent cage 150A and at a reduced temperature that is less than the temperature of the heated cooling fluid that exits the rear of the cage 150A.

Targeted cooling device 165-1 may include a pump that can pump water from first cooling chamber 122-1 into cage 150A-1. Pump P can draw in cooling fluid 110 around cage 150A-1 and distribute the cooling fluid 110 both upstream and downstream of heated components, such as the one or more microelectronic elements 168-1. The ability to direct cooling fluid downstream of microelectronic elements 168-1 and into the rear of cage housing 151 where elements adjacent outflow end 160 are positioned. In other examples, a propellor or a fan can be implemented as targeted cooling devices 165 to direct cooling fluid 110 in a direction towards the rear of cage housing 151 and those elements that are closest to outflow end 160, which in this example are elements 166E. Similarly, in other examples, a plurality of vanes may be arranged to allow for the flow of cooling fluid in only one direction.

FIG. 9 illustrates another immersion cooling system 200. Immersion cooling system 200 is identical to cooling system 100, except that cooling system 200 includes a secondary cooling fluid supply 213 and secondary cooling supply manifold 207 that can feed cooling fluid directly into selected or targeted locations within the cages 250. In this example, secondary cooling supply manifold 207 may be positioned toward the bottom of immersion unit 220 and in some example, adjacent main manifold 205. In other examples, the secondary cooling supply manifold 207 may be positioned elsewhere, such as at the top or along the side of immersion cooling tank. Connectors, such as but not limited to blind mate connectors 209 can connect secondary cooling supply manifold 207 to local cooling components, which may include hoses and/or other piping equipment which distribute a second source of cooling fluid or a secondary cooling fluid into system 200 and immersion cooling unit 220. Supply lines 218, such as hoses, that are connected to secondary cooling supply manifold 207 can be arranged to provide secondary cooling fluid directly to cages 250 and to specific IT equipment or components within cages 250 through nozzles 219 that are positioned in the area of the IT equipment or components to be cooled. In this example, secondary cooling fluid may be the same dielectric cooling fluid within the rest of immersion unit 220 or it may differ from the dielectric cooling fluid in immersion unit 220.

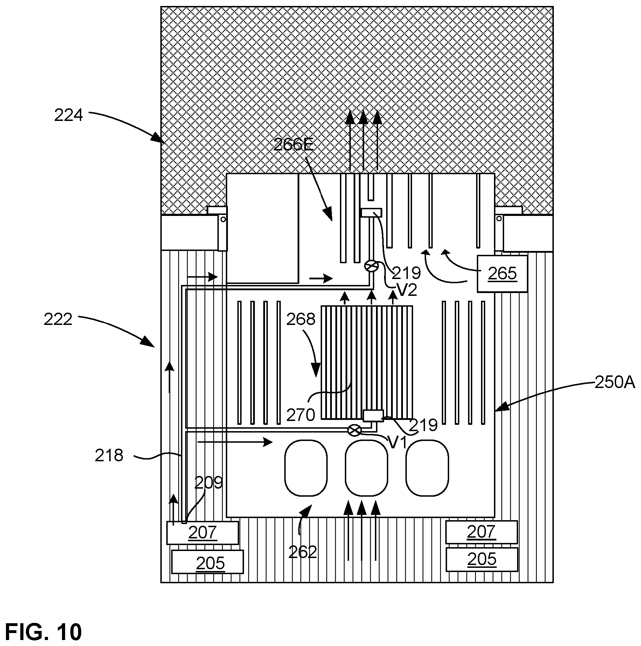

FIG. 10 illustrates an example cage 250A positioned within immersion unit 220. As shown, cooling fluid from a secondary source may be directed to components internal to cage 250A. In this example and as previously described, components can include at least one microelectronic element 268, such as a semiconductor chip, which may be positioned within or adjacent cold plate 270, as well as other microelectronic elements, such as but not limited to DIMMs 266E. Localized cooling with the addition of a secondary cooling fluid source and local cooling element 265 can enhance the cooling of components downstream of the chip 268 that otherwise received heated fluid as the fluid absorbs heat from upstream components. In this example, nozzles 219 are positioned downstream of chip 268 to provide a directed flow to the exterior of chip 268. The additional local cooling element 265 which draws in cooling fluid external to cage 250A further enhances downstream cooling.

The cooling fluid in secondary supply 213 may be a dielectric cooling fluid that is the same as the cooling fluid in supply manifold 205 and/or one that is compatible with cooling fluid within first and second cooling chambers 222, 224. Similarly, since the cooling fluid is intended to provide for cooling of components downstream of heated cooling fluid, a fluid with enhanced thermal properties may instead be used. In examples where it is desired to introduce an alternative fluid or a fluid that is not compatible with the cooling fluid filling the immersion tank, such as water, a closed system can be implemented, as will be disclosed herein.

Valves V1, V2 may be provided along the supply lines 218 or in other examples, valves V1, V2 may be directly incorporated into nozzles 219, to help regulate the flow of cooling fluid through the supply lines 218. Various types of valves can be implemented and may be any conventional valve configured to regulate fluid flow. Valves can include, without limitation, ball valves and check valves, such as butterfly check valves. For example, without limitation, each valve V1,V2 may have an adjustable opening and include one or more movable walls or dampers that can increase or decrease the size of the opening. When the size of the opening of valve V1, V2 is increased, the flow and amount of cooling fluid through valves V1, V2 also increases. When the size of the opening of valves V1, V2 is decreased, the flow and amount of cooling fluid through respective valves V1, V2 also decreases. Valves V1, V2 can also be remotely and automatically monitored and controlled, as will be discussed in further detail herein.

As shown, supply lines 218 may extend internally through cages 250A to allow for easy connection to secondary cooling supply manifold 207. Hoses 218 may be directly or indirectly coupled to nozzles 219 within the cage. In some examples, the portion or lengths of supply lines 218 that are coupled to nozzles 219 and extend internally through cage 250 may include an intermediate connector that can be accessed external to and/or directly adjacent the cage 250. This can provide for a cage 250 with an internal set of hoses 218 configured to easily connect either directly to the secondary supply 207 and/or another length of hose that extends between the secondary supply 207 and the intermediate connector. This can provide added flexibility to position the secondary supply 213 at any position relative to the immersion tank.

In some examples, cooling may be regulated based on either or both of temperature and pressure feedback. For example, sensors may be placed at any point within IT cage 250 and at the nozzles 219, or may be provided adjacent cold plate 270 and components 266.

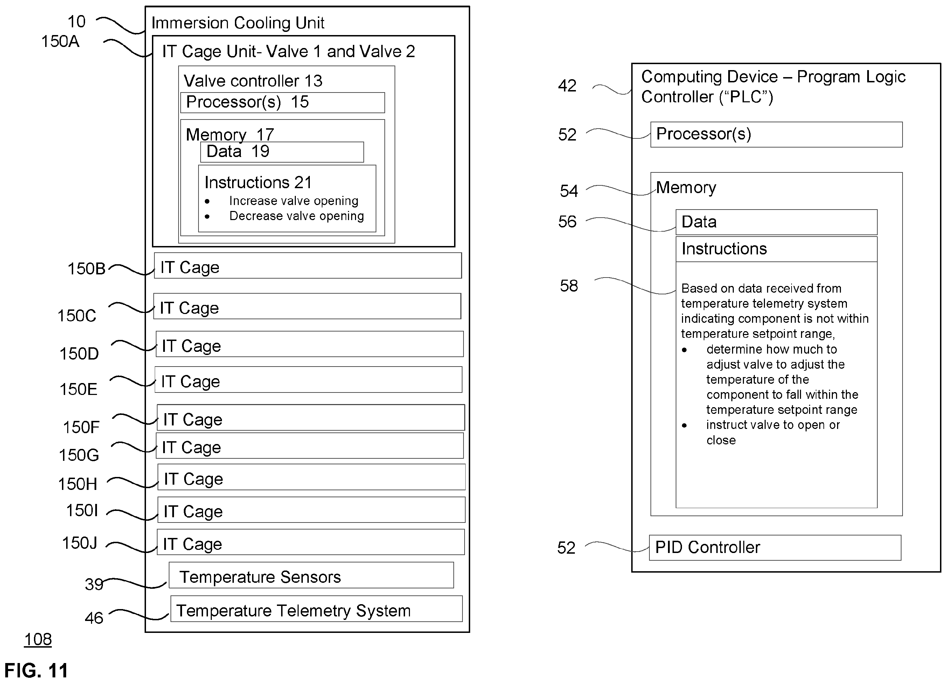

FIG. 11 illustrates an example control system 1 in which the features described above and later herein may be implemented. Example control system 1 should not be considered as limiting the scope of the disclosure or usefulness of the features described herein. As shown in this example, system 1 can include immersion control system. Immersion cooling unit 10 may further include temperature telemetry system 46, which can obtain, store, and analyze information about current cooling fluid temperature and cooling fluid flow rate in the system, within each of the cages and at each nozzle. Sensors 39 can provide information about components within each cage, including without limitation, temperature, to temperature telemetry system 46.

Each cage 150A-150J can include valve controller 13 that is directly or wirelessly coupled to computing device or PLC 42, including via short-range communication. Valve controller 13 can be any computing device or accessory and can control valves in each cage.

One or more processors 15 may be any conventional processors, such as commercially available microprocessors. Alternatively, the one or more processors 15 may be a dedicated device such as an ASIC or other hardware-based processor. Although the processor, memory, and other elements of controller 13 are depicted as being within the same block, it will be understood by those of ordinary skill in the art that the processor, computing device, or memory may actually include multiple processors, computing devices, or memories that may or may not be stored within the same physical housing. Similarly, the memory may be a hard drive or other storage media located in a housing different from that of computing device. Accordingly, references to a processor or computing device will be understood to include references to a collection of processors or computing devices or memories that may or may not operate in parallel.

Memory 17 of each cage may store information that is accessible by the processor(s) 15, including instructions 21 that may be executed by the processors 15. Memory 17 may be a type of memory operative to store information accessible by the processors 15 including a non-transitory computer-readable medium, or other medium that stores data that may be read with the aid of an electronic device, such as a hard drive, memory card, read-only memory ("ROM"), random access memory ("RAM"), optical disks, as well as other write-capable and read-only memories. The subject matter disclosed herein may include different combinations of the foregoing, whereby different portions of the instructions 21 and data 19 are stored on different types of media.

Memory 17 for each cage 150A-150J may be retrieved, stored, or modified by processors 15 in accordance with instructions 21. For instance, although the present disclosure is not limited by a particular data structure, data 19 may be stored in computer registers, in a relational database as a table having a plurality of different fields and records, in XML documents, or in flat files. Data 19 may also be formatted in a computer-readable format such as, but not limited to, binary values, ASCII, or Unicode. By further way of example only, data 19 may be stored as bitmaps comprised of pixels that are stored in compressed or uncompressed form, or as various image formats (*e.g.*, JPEG), vector-based formats (*e.g.*, SVG), or as computer instructions for drawing graphics. Moreover, data 19 may comprise information sufficient to identify the relevant information, such as numbers, descriptive text, proprietary codes, pointers, references to data stored in other memories (including other network locations), or information that is used by a function to calculate the relevant data.

Instructions 21 for each of the valves V1, V2 within cages 150A-150J can be any set of instructions to be executed directly, such as machine code, or indirectly, such as scripts, by the processor 15. In that regard, the terms "instructions," "application," "steps," and "programs" can be used interchangeably herein. The instructions can be stored in object code format for direct processing by the processor, or in any other computing device language including scripts or collections of independent source code modules that are interpreted on demand or compiled in advance. Functions, methods, and routines of the instructions are explained in more detail below. In this example, instructions can be provided to components of immersion cooling unit 10, such as valves V1, V2 in cage 150A, as well as corresponding valves in each of the cages.

PLC 42 may be coupled with immersion unit 10 via a direct and/or wireless connection. For instance, a wireless communication interface may be used to transmit and receive Bluetooth signals, WiFi signals, or signals that use other short-range wireless technologies. The features of PLC 42, processor(s) 52, memory 54, and data 56 may be the same as previously described herein with regard to immersion cooling unit 10 above. PLC 42 may communicate and receive data from temperature telemetry system 46 of immersion cooling unit 10. PLC 42 can then instruct each cage 150A-150J regarding adjustments to features within each cage 150A-150J, and in this example adjustments to valves V1, V2 in each cage.

Turning now to control of valve V1 and valve V2 in each cage 150A-150J, the size of the opening of control valves within each cage may be controlled by control system 1, which can include PLC 42, temperature telemetry system 46, and valve controller 13. PLC 42 may communicate with temperature telemetry system 44 and each valve controller 13 to determine when it is necessary to modify the size of the opening of valves V1 and V2.

The desired position or size of the opening of valves V1, V2 at any given time may be a function of the current temperature of each respective component which is to be cooled by secondary cooling fluid. Control system 1 can modify the size of the opening of valve V1 based upon the predetermined component temperature setpoint range, which can be compared to the actual temperature of the component to determine whether the component temperature falls within the setpoint range. For example, first temperature setpoint range T1_{SETPOINT} may correspond to V1 and a second temperature range setpoint T2_{SETPOINT} may correspond to V2. Actual temperature of each component may be determined based on a temperature reading from a sensor positioned at each component. For example, TI_{ACTUAL} may correspond to high-power chip 168 and T2_{ACTUAL} may correspond to actual temperature of DIMM 166E.

When temperature T1A_{CTUAL} does not fall within the first temperature setpoint range T1_{SETPOINT} and is less than temperature setpoint range T1_{SETPOINT}, this is an indication that the temperature of the component, which in this example, is high-power chip 168, is lower than the temperature that is necessary to maintain the predetermined cooling conditions. In this example, the amount of secondary cooling fluid dispersed can be decreased. For example, the size of the opening of valve V1 may be decreased by a certain percentage. In one example, PLC 42 can communicate with valve controller 13 and instruct valve controller 13 to decrease the size of the valve V1 opening.

When temperature T1_{ACTUAL} does not fall within the first temperature setpoint range T1_{SETPOINT} and is greater than temperature setpoint range T1_{SETPOINT}, this may be an indication that the current temperature of the chip 168 is too high and needs to be cooled down. In this example, PLC 42 can communicate with valve controller 13 and instruct valve controller 13 to adjust valve V1 to allow for more secondary cooling fluid to flow through nozzle, which will help cool down chip 168. For example, the size of the opening of valve V1 may be increased. Further, the increase in a size of the opening of valve V1 may be a certain percentage increase. The increased flow of secondary cooling fluid directly to chip 168 can help to enhance cooling of chip 168.

When temperature T1_{ACTUAL} falls within first temperature setpoint range T1_{SETPOINT}, this may indicate that the cooling fluid is at an optimal temperature. In this example, the temperature of chip 168 is sufficient, such that it is unnecessary to adjust or modify the size of the opening of valve V1 to provide increased cooling. PLC 42 may communicate with valve controller 13 and instruct valve controller 13 to take no action and to maintain the current conditions.

It is to be appreciated that instead of a range, an exact temperature can be selected as a temperature setpoint T1_{SETPOINT}. Similarly, the same procedure can be followed to modify valve V2, which controls flow of secondary cooling fluid to a second component, which in this example may be a DIMM 166D near outflow end 160 of cage 150A.

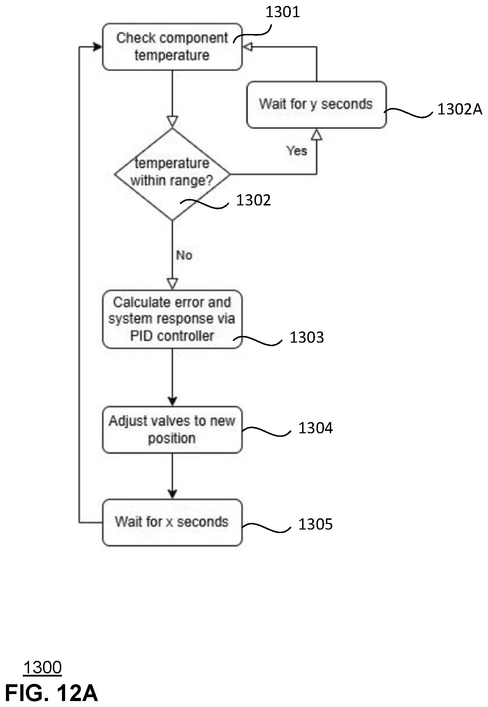

FIG. 12A is a flow chart illustrating one example method 1300 of controlling the amount of secondary cooling fluid flowing directly to a component within an IT cage. In particular, method 1300 teaches control of a valve that controls flow of secondary fluid to a specific component in IT cage, and in this example, concerns controlling the size of the opening of a valve, such as V1 or V2, to allow for the increase or decrease of secondary cooling fluid directed to each component.

At block 1301, a component temperature is determined. For example, a sensor may indicate the actual temperature of chip 168 in cage 150A.

At block 1302, actual temperature of chip 168 is compared to a predetermined temperature setpoint range T1_{SETPOINT} of chip 168. If the actual temperature is within the temperature setpoint range T1_{SETPO1NT}, at block 1302A a predetermined time delay may be implemented before going back to block 1301 and checking component temperature. If at block 1302 the actual temperature of chip 168 is not within the range, a controller can be used to further adjust the flow of the secondary cooling fluid to reduce the actual temperature of chip 168.

At block 1303, a controller may be configured to calculate the error and determine how to adjust the flow of the secondary cooling fluid to reduce the actual temperature of chip 168. As shown in one example, a PID controller can be implemented, which in some examples, may be a proportional integral derivative controller or a feedback controller configured to make adjustments to achieve a desired target value. In one example, based on temperature feedback from a sensor positioned near one or more components within cage 150A, the PID controller can determine whether the one or more chips 168 requires more cooling and/or an increase of cooling fluid, less cooling and a reduction in fluid, or no change is required. Based on feedback from a sensor, the PID controller may further adjust one or both valves V1, V2 based on feedback received from the sensor.

At block 1304, the valve is adjusted to a new position based on instructions from PID controller.

At block 1305, a predetermined time delay is taken. For example, a predetermined number X of seconds can pass before the process begins again at block 1301. The predetermined number or time delay can be any desired time delay, including without limitation, a millisecond, minutes, or hours.

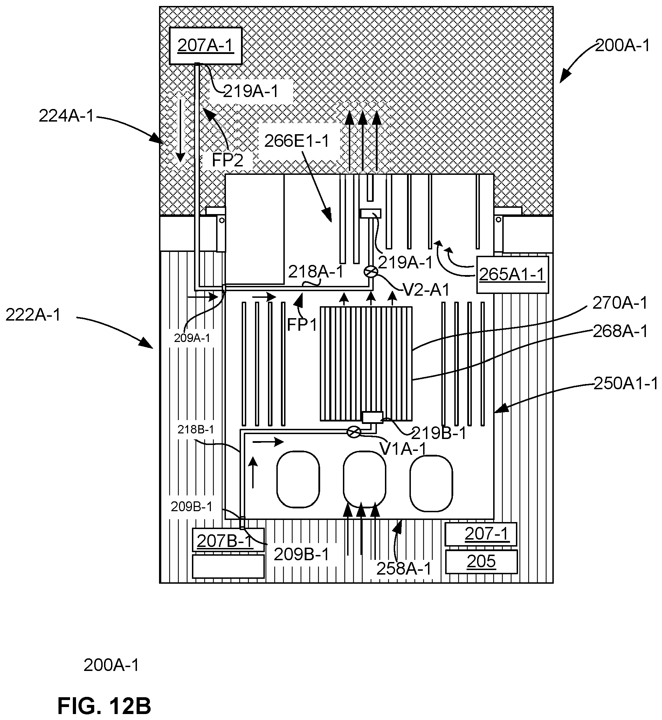

With reference to FIG. 12B, another example cooling system 200A-1 is shown that includes components similar to system 200, except for the addition of another secondary supply and supply manifold 207A-1 that provides cooling fluid directly into cage 250A1-1. The secondary supply of cooling fluid can be positioned anywhere relative to immersion cooling unit 220A-1. In this example, secondary supply manifold 207A-1 may include a manifold that is positioned toward the top of immersion cooling unit 220A-1, which in this example is on a side of partition chamber wall 128A-1 that is opposite the side of the partition chamber wall 128A-1 closest to cage 250-1. Additional secondary supply manifold 207A-1 is shown positioned within second cooling chamber 224A-1, but in other examples additional secondary supply manifold 207A-1 and/or primary secondary supply 207A1-1 may be positioned elsewhere, such as but not limited to the exterior of immersion unit 220A-1 or the lid of the immersion unit.

Line 218A-1 may be positioned downstream of one or more microelectronic elements 268-1 to introduce another source of cooling fluid from another secondary supply manifold 207A-1 to downstream components, such as DIMMs 266E-A1 and power unit 207A-1. For example, line 218A-1 may couple secondary supply manifold 207A-1 and fluid distribution element 219-1, such as a nozzle, together.

In this example, line 218A-1 includes a first portion FP1 and second portion FP2. First portion FP1 includes a connector 209A-1 that allows for interconnection to a second portion FP2 of line 218A-1 that is coupled to connector 209A-1 of the secondary supply manifold 207A-1. This allows cage 250A-1 to include lines that are positioned internal to cage 250A-1 and that are configured to easily connect with an intermediate line that is external to cage 250A-1 and/or to directly connect to connector 219A-1 of secondary supply manifold 207A-1. As in previous examples, line 218A-1 can include, without limitation, hoses, pipes, or any other structure that allows for the distribution of cooling fluid from a supply to another location or device, such as the nozzle. In examples where cage 250A-1 is positioned within a dual chamber immersion cooling unit and the secondary supply manifold 207A-1 is positioned on a side opposite the side adjacent the cage 250A-1, an opening 229-1 can be created within the partition chamber wall adjacent a side of partition chamber wall 228-1.

As in the prior example, line 218B-1 further couples secondary supply 207B1-1 to nozzle 219B-1, which is positioned upstream of one or more semiconductor chips 268A-1. Line 218B-1 may include a connector 209B-1 that is coupled to nozzle 219B-1 and includes valve V1A1. But, in other examples, line 218B-1 can be coupled to another secondary supply 207A1-1 that is positioned towards the top of immersion unit 220A-1 or anywhere relative to immersion unit 220A-1.

As in the prior examples, in use, cooling fluid will enter cage 250A1-1 through inflow end 258A-1 of cage 250A1-1 and flow through and around IT equipment, including microelectronic devices housed within cage 270A-1. Cooling fluid will flow through and around cold plate 270A-1 and through downstream components positioned downstream of cold plate 270A-1 and microelectronic element 268A-1.

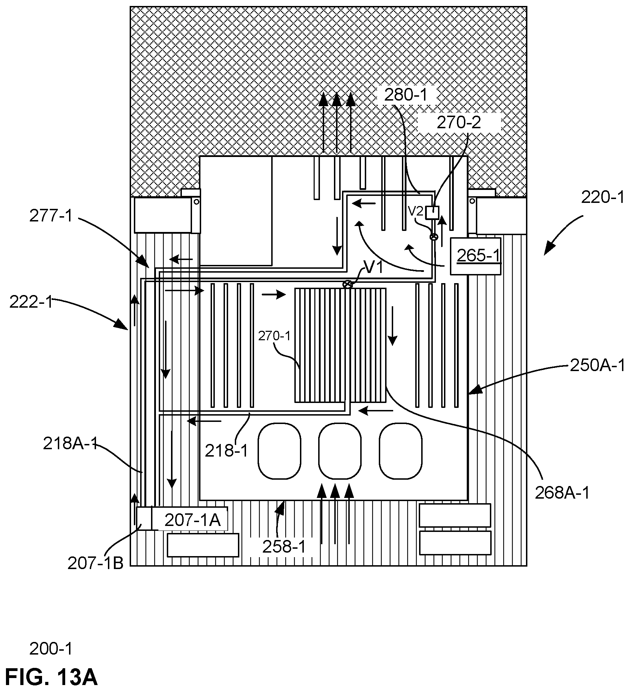

FIG. 13A shows another cooling system 200-1 that further incorporates a local spot cooling system. Cooling system 200-1 is similar to the cooling system disclosed in FIG. 10, but further includes a secondary cooling system, which is a closed cooling loop 277-1 that extends through cage 250A-1, also referred to herein as a closed-loop cold plate assembly. One or more microelectronic elements 268A-1, such as chips or processors may act as a primary heat generating components. In some examples, the one or more microelectronic elements may be enclosed by or thermally coupled to a first enclosed cold plate 270-1 or a housing that encompasses both cold plate 270-1 and one or more microelectronic elements. One or more chips may be enclosed by a second enclosed cold plate 270-2 or a housing encompassing both cold plate 270-2 and the one or more chips 268B-2. that can enclose a further microelectronic element or a high heat producing device. As shown, supply line 218-1 feeds cooling fluid to cold plate 270-1 through valve V1, which controls flow to first cold plate 270-1. As cooling fluid flows over and through enclosed cold plate 270-1, heat from one or more microelectronic elements underlying cold plate 270-1 is transferred to the cooling fluid. Heated cooling fluid exits and follows line 218-2 to valve V2-2 to feed fluid through first cold plate 270-2A and one or more microelectronic elements 268-2B, such as chips or processors. Cooling fluid in line 218-2 that bypasses or extends around cold plate 270-1A will cool down heated fluid exiting cold plate 270-1A. The cooling fluid then flows to valve V2 and through second cold plate 270-2A. The heated return fluid then flows through return line 280-1 and returns through a return manifold 207-1B where the heated return fluid is processed, cooled, such as through a heat exchanger, and then supplied again through supply manifold 207-1 into cage 250A-1. Similarly, as cooling fluid flows over second cold plate 270-2, heat from microelectronic elements being cooled by second cold plate 270-2 is transferred to the cooling fluid. Heated cooling fluid then flows through return line 280-2. Optional cooling device 265-1 may also help to increase cooling by drawing cooling fluid from first cooling chamber 222-1 into cage 250A-1, and particularly to provide spot cooling.

Cooling fluid from immersion unit 220-1 and first cooling chamber 122-1 is also shown flowing through inlet end 258-1 of cage 250A-1 and through cage 250A-1. This provides further cooling of IT equipment within cage 250A-1, as well as around the periphery of cold plate 270-1.

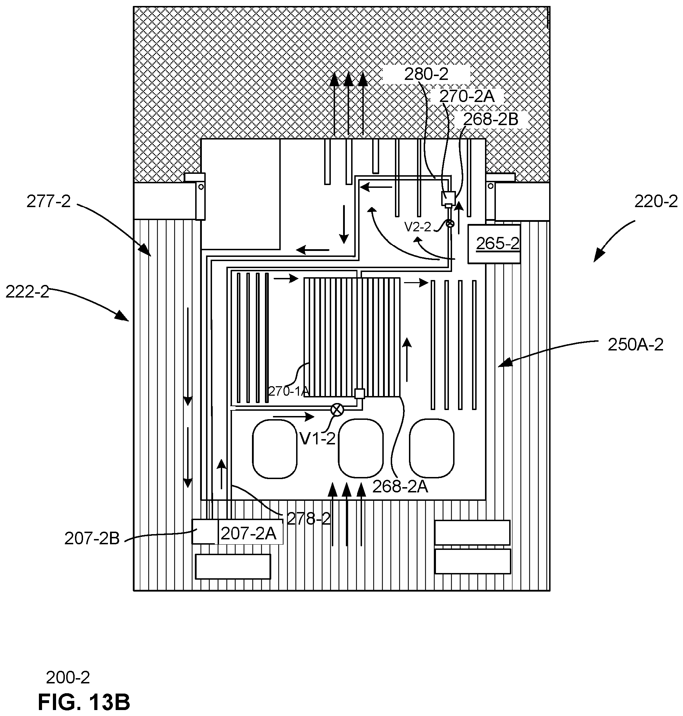

FIG. 13B shows another local spot cooling system which is similar to FIG. 13A and implements a secondary cooling system, which in this example is a closed cooling loop 277-2 that extends through cage 250A-1. Similar features from FIG. 13A are also incorporated herein, with the difference in system 200-2 being that some of the targeted cooling fluid directed to IT equipment, including microelectronic devices, such as chips, and downstream components flows in a different direction and vertical lengths of the lines are also depicted as being housed within cage 250A-2.

One or more microelectronic devices 268-1A, such as high power chips, may optionally be enclosed and/or positioned adjacent a first enclosed cold plate 270-1A. One or more microelectronic devices 268-2B, such as high power chips, may be enclosed and/or or positioned adjacent a second cold plate 270-2A. As shown, supply line 218-1 feeds secondary cooling fluid to cold plate 270-1A through valve V1-2, which controls fluid flow to first cold plate 270-1A. As cooling fluid flows through cage 250A-1, including over, though, and/or around cold plate 270-2 and one or more chips 268A, heat from one or more microelectronic elements 268-2 underlying cold plate 270-2 is transferred to the cooling fluid. The heated return fluid then flows through return line 218-2 and exits cage 250A-2 back to fluid supply source where heated cooling fluid is cooled and then returned through manifold 270-2.

The remaining IT components within cages 250 that are not subject to targeted cooling are cooled via immersion cooling. As cooling fluid flows over second cold plate 270-3, heat from microelectronic elements being cooled by second cold plate 270-3 is transferred to the cooling fluid. Heated cooling fluid then flows through return line 280-2. Optional cooling device 265-2 may also help to increase cooling by drawing cooling fluid from first cooling chamber 222-2 into cage 250A-2, and particularly to provide spot cooling, as previously described and incorporated herein.

A closed system, such as a closed-loop cold plate assembly, for providing a secondary supply of cooling fluid from a source external to the tank enclosure, including those closed system previously described or to be described herein, can allow for the same or a different type of cooling fluid than the cooling fluid within the immersion units 220-1, 220-2 to be supplied through the secondary supply source and manifold. Such differences may include, without limitation, a fluid having a different fluid composition. For example, the secondary cooling fluid may be the same dielectric fluid as in the immersion cooling unit 220-2 or it may differ. In examples where the fluid differs, cooling fluid with enhanced properties to promote cooling can be implemented. Cooling fluid in secondary supply 213 may also be water, such as municipal water, that is routed to the targeted areas of the cages to further enhance cooling of components within cooling system 200. The municipal water may have a different fluid composition than the cooling fluid contained in the interior space of the tank enclosure. In this example, a secondary fluid can be used to directly cool components consuming high amounts of power.

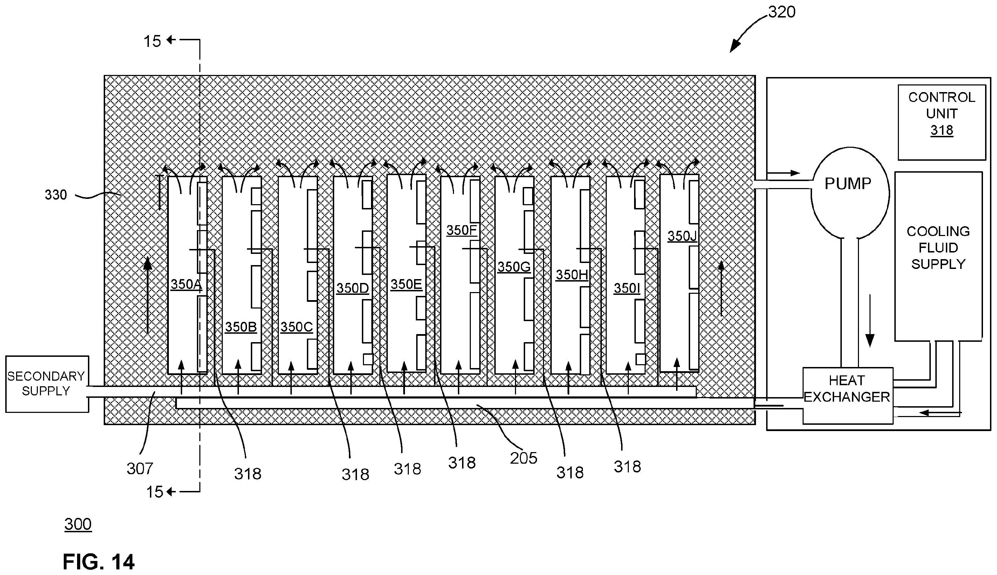

FIGS. 14-15 depict an example system 300 in which water cooling through a secondary loop and immersion cooling using dielectric fluids are combined to achieve cooling of components within cages 350A-350J. System 300 differs from the prior examples only to the extent that immersion unit 320 does not include an intermediate chamber partition wall. Instead, cages 350A-350J (collectively "cages 350") may be secured within immersion unit 320 using any known means. For example, one or more shelves, racks, or other equipment may be provided within the interior space 330 of immersion unit 320. These components can be directly or indirectly supported by any portion of immersion unit 320 or a component external to immersion unit 320.

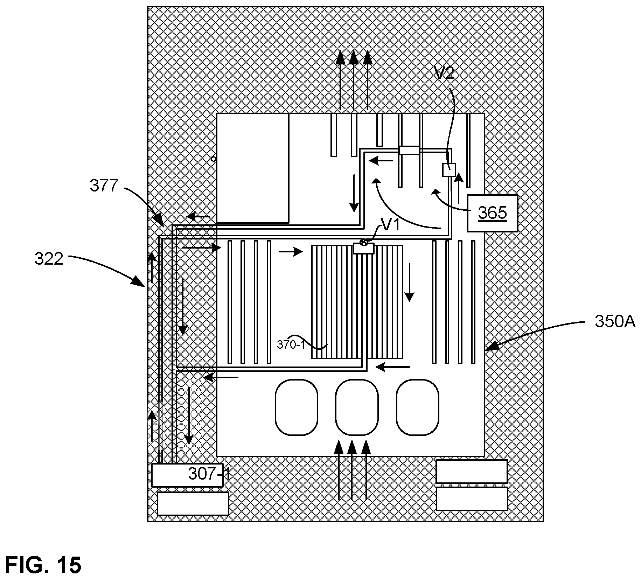

As shown in FIG. 15, a secondary and localized cooling system 377 can allow for a secondary supply of cooling fluid through secondary manifold 307 to flow through piping or hoses 318 directly to IT equipment requiring high power and generating extreme amounts of heat. Secondary supply may flow through cage 350A in the direction of the arrows shown in FIG. 15. In this example, secondary cooling fluid may be a different type of fluid than the cooling fluid within immersion cooling unit 120. In one example, the secondary cooling fluid may possess good thermal properties, such as water, including municipal water. As in the previous examples, valves V1 and V2 may be controlled by control unit, such as valve controller 13 s and PLC previously described in FIG. 11, to regulate the flow of cooling fluid through secondary pipes. Valve controller 13 may adjust valves V1,V2 based on any number of factors. In one example, valves V1, V2 may be adjusted based on temperature feedback from sensors positioned at the chips and/or other IT equipment within IT cage, as previously described herein. Optionally, cooling device 365 may further be included that can draw in cooling fluid exterior to cage 350A into cage 350A.

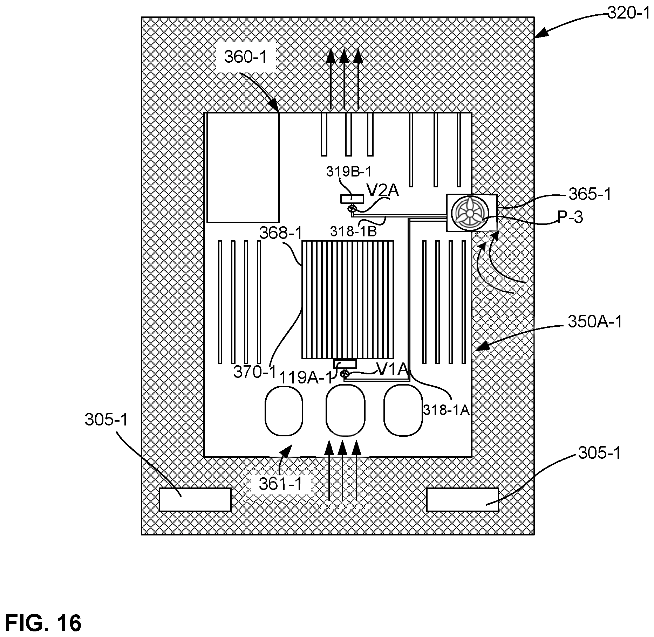

Any of the cages and/or secondary cooling systems previously described herein can be implemented within a single chamber immersion chamber. Turning to another example, FIG. 16 illustrates cage 150A-1 from FIG. 8B, which is identified in FIG. 8B as cage 350A-1. Cage 350A-1 is positioned within an immersion cooling unit 320-1 that does not include a partition chamber wall and is otherwise a single chamber immersion unit. The features will not be described again for brevity of discussion. In use, cooling fluid from manifolds 305-1 flow through inflow opening 361-1 of cage 350A-1. As in the example of FIG. 8B, cooling fluid will flow through inflow opening 361-1 and through cage 350A-1. Cooling fluid is heated downstream of the cold plate 370-1 and microelectronic elements 368-1. Local cooling unit 365-1 can draw in fluid from immersion unit 320-1 to introduce a new stream of cooling fluid downstream of the cold plate 370-1, as well as at the entrance to cold plate 370-1. Heated cooling fluid exits cage 350A-1 through outflow end 160 of cage 350A-1.

An information technology (IT) cage for immersion liquid cooling includes a cage housing, IT equipment housed within the primary internal passageway of the cage housing, and a localized cooling sub-system. The cage housing has an inflow end and an outflow end. The cage housing defines a primary internal passageway configured to allow a passive bulk flow of a cooling fluid from the inflow end to the outflow end. The IT equipment is housed within the primary internal passageway of the cage housing. The IT equipment comprises at least one primary heat-generating component and at least one secondary component positioned downstream of the at least one primary heat-generating component relative to the passive bulk flow. The localized cooling sub-system may be coupled to the cage housing. The localized cooling sub-system may further comprise a targeted cooling device configured to draw a secondary flow of the cooling fluid from an exterior of the cage housing. The localized cooling sub-system may be oriented to direct the secondary flow of the cooling fluid toward the at least one secondary component to bypass the passive bulk flow heated by the at least one primary heat-generating component; and/or
the at least one primary heat-generating component is a microelectronic element; and/or
the at least one primary heat-generating components comprises a semiconductor chip; and/or
the at least one primary heat-generating component comprises a processor; and/or
the localized cooling sub-system further comprises a first internal dedicated line; a first fluid distribution element; and a first control valve coupled to the first internal dedicated line. The first internal dedicated line may be disposed within the cage housing and is fluidly coupled to the targeted cooling device. The first fluid distribution element may be coupled to the first internal dedicated line and positioned adjacent the at least one secondary component. The first control valve may be configured to regulate a distribution of the secondary flow of the cooling fluid toward the at least one secondary component; and/or
the localized cooling sub-system further comprises a second internal dedicated line and a second control valve coupled to the second internal dedicated line. The second internal dedicated line may be disposed within the cage housing and fluidly coupled to the targeted cooling device. The second fluid distribution element may be coupled to the second internal dedicated line and positioned upstream of the at least one primary heat-generating component. The second control valve may be configured to regulate a distribution of the secondary flow of the cooling fluid onto the at least one primary heat-generating component; and/or
the targeted cooling device comprises a pump coupled to the cage housing; and/or
the cage further comprises a supply line connector configured to removably couple with a secondary supply manifold positioned external to the cage housing; and/or
the first fluid distribution element comprises a nozzle oriented to inject the secondary flow into the primary internal passageway at a higher pressure than a pressure of the passive bulk flow; and/or
a valve controller is in communication with the first control valve. The valve controller may be configured to automatically adjust an opening size of the first control valve based on temperature data associated with the at least one secondary component; and/or
the at least one primary heat-generating component comprises a microelectronic processor, and the secondary component is positioned nearer to the outflow end of the cage housing than the microelectronic processor; and/or
the at least one primary heat-generating component is adjacent a cold plate; and/or
the targeted cooling device is positioned at a vertical height along the cage housing that is lower than a vertical height of the at least one secondary component.

According to another aspect of the disclosure, a system for cooling information technology (IT) equipment comprises an immersion cooling unit, at least one IT cage, a cage housing, IT equipment, and a localized cooling sub-system. The immersion cooling unit may comprise a tank enclosure that has an interior space containing a volume of a cooling fluid. At least one IT cage may be positioned within the interior space and at least partially submerged in the cooling fluid. The at least one IT cage comprises a cage housing having an inflow end and an outflow end. The cage housing defines a vertical passageway for a primary upward bulk flow of the cooling fluid. The IT equipment may be housed within the cage housing and comprise a primary heat-generating component and a secondary downstream component positioned closer to the outflow end than the primary heat-generating component. The localized cooling sub-system coupled to the at least one IT cage. The localized cooling sub-system may comprise a targeted cooling device configured to draw a localized portion of the cooling fluid from the interior space exterior to the cage housing. The localized cooling sub-system may be configured to inject the localized portion of the cooling fluid directly toward the secondary downstream component to bypass the primary upward bulk flow heated by the primary heat-generating component; and/or
the at least one primary heat-generating component is a microelectronic element; and/or
the at least one primary heat-generating components comprises a semiconductor chip; and/or
the at least one primary heat-generating component comprises a processor; and/or
the localized cooling sub-system further comprises internal piping fluidly coupled to the targeted cooling device and at least one control valve situated on the internal piping to regulate a flow rate of the localized portion of the cooling fluid; and/or
the interior space of the immersion cooling unit comprises a first cooling chamber, a second cooling chamber, and a partition chamber wall separating the first cooling chamber from the second cooling chamber; and/or
the at least one IT cage is positioned through an opening in the partition chamber wall such that the inflow end is located within the first cooling chamber, the outflow end is located within the second cooling chamber, and the targeted cooling device is positioned on an exterior of the cage housing at a vertical height entirely within the first cooling chamber; and/or
the system further comprises a secondary fluid supply manifold positioned within the interior space of the immersion cooling unit. The targeted cooling device of the at least one IT cage may comprise a connector removably coupled to the secondary fluid supply manifold to receive the localized portion of the cooling fluid; and/or
the system further comprises a programmable logic controller (PLC) and at least one temperature sensor positioned adjacent the secondary downstream component. The PLC may be configured to: receive actual temperature data from the at least one temperature sensor; determine whether the actual temperature data falls outside a predetermined temperature setpoint range; and transmit an instruction to automatically adjust a flow rate of the localized cooling sub-system; and/or
the at least one IT cage further comprises a closed-loop cold plate assembly thermally coupled to the primary heat-generating component. The closed-loop cold plate assembly may be configured to receive a secondary cooling fluid from a source external to the tank enclosure. The secondary cooling fluid may have a different fluid composition than the cooling fluid contained in the interior space.

According to an aspect of the disclosure, an immersion unit for immersion liquid cooling includes a tank enclosure, a first cooling chamber, a second cooling chamber, and a partition chamber wall. The tank enclosure includes an interior space configured for immersion of information technology ("IT") equipment within the tank enclosure. The first cooling chamber may include an inlet for receiving cooling fluid from a cooling fluid supply external to the tank enclosure. The second cooling chamber may have an outlet for recirculating heated cooling fluid within the second cooling chamber to the external cooling fluid supply. The heated cooling fluid may be cooling fluid from the first cooling chamber that is increased in temperature due to convention. The partition chamber wall may be positioned within the interior space. The partition chamber wall may further include a top surface and a bottom surface. The petition chamber wall may extend substantially across a length and width of the interior space. The partition chamber wall may further separate the interior space into the first cooling chamber and the second cooling chamber. In this configuration, the top surface of the partition chamber wall defines a bottom surface of the second cooling chamber and the bottom surface of the partition chamber wall defines a top surface of the first cooling chamber. The partition chamber wall may have a plurality of wall openings that extend through the top and bottom surfaces of the partition chamber wall. The partition chamber wall may be configured to receive a plurality of IT cages housing the IT equipment and that are positioned within a corresponding one of the plurality of wall openings. The partition chamber wall may be configured to allow for each of the plurality of IT cages to be positioned within the first cooling chamber and the second cooling chamber at the same time during immersion cooling; and/or
the partition chamber wall further includes a plurality of panels. Each of the plurality of panels may overlie a corresponding one of the plurality of openings. Each of the plurality of panels may be configured to move from a closed position where the corresponding opening is closed and cooling fluid is unable to pass therethrough and an open position where the corresponding opening is open and cooling fluid can pass therethrough; and/or
each of the plurality of panels is a single panel and each single panel overlies the corresponding one of the plurality of openings. Each of the plurality of openings has a width and each single panel has a length that is equal to or greater than the width; and/or
each of the plurality of panels is a pair of panels and each pair of the panels overlies the one of the plurality of openings. Each of the plurality of openings has a width and each pair of panels collectively has a combined length that is equal to or greater than the width of the opening; and/or
at least one or more portions of the partition chamber wall is fixed to the tank housing; and/or
the tank enclosure includes a tank bottom surface and a peripheral wall extending away from the tank bottom surface and around a tank opening. The tank enclosure may have a total height measured from the tank bottom surface to a top surface of the peripheral wall. The partition chamber wall may be movable along a total height of the peripheral wall so as to allow for adjustment of a second height of the first cooling chamber and a third height of the second cooling chamber. The second height and the third height are each less than the total height; and/or
the second height of the first cooling chamber is at least 50% of the total height; and/or
the second height of the first cooling chamber ranges between 40% and 70% of the total height; and/or
a pair of ledges positioned along a length of the immersion unit, the plurality of cages may be coupled to the pair of ledges; and/or
the top surface defines a surface of the second cooling chamber and the bottom surface defines a surface of the first cooling chamber, and the plurality of wall openings comprise five or more openings extending through the partition chamber wall.

According to another aspect of the disclosure, a system for cooling IT equipment includes an immersion unit, a cooling fluid, and a heated cooling fluid. The immersion unit of the system further includes a tank enclosure, a first cooling chamber, a second cooling chamber, and a partition chamber wall. The cooling fluid may be disposed within the first cooling chamber and has a first temperature. The heated cooling fluid within the second cooling chamber may have a second temperature greater than the first temperature. The tank enclosure of the cooling unit can further include an interior space that is configured to immerse IT equipment within the tank enclosure. The first cooling chamber may include an inlet for receiving cooling fluid from a cooling fluid supply external to the tank enclosure. The second cooling chamber may have an outlet for recirculating heated cooling fluid within the second cooling chamber to the external cooling fluid supply. The heated cooling fluid may be cooling fluid from the first cooling chamber that is increased in temperature due to convention. The partition chamber wall may be positioned within the interior space. The partition chamber wall may further include a top surface and a bottom surface. The petition chamber wall may extend substantially across a length and width of the interior space. The partition chamber wall may further separate the interior space into the first cooling chamber and the second cooling chamber. In this configuration, the top surface of the partition chamber wall defines a bottom surface of the second cooling chamber and the bottom surface of the partition chamber wall defines a top surface of the first cooling chamber. The partition chamber wall may have a plurality of wall openings that extend through the top and bottom surfaces of the partition chamber wall. The partition chamber wall may be configured to receive a plurality of IT cages housing the IT equipment and that are positioned within a corresponding one of the plurality of wall openings. The partition chamber wall may be configured to allow for each of the plurality of IT cages to be positioned within the first cooling chamber and the second cooling chamber at the same time during immersion cooling.
and/or a temperature difference between the cooling fluid and the heated cooling fluid ranges from 5°C to 10°C;
and/or the temperature difference ranges from 4°C to 8°C; and/or
the temperature difference is greater than 5°C; and/or
the system further includes a plurality of IT cages. Each of the plurality of IT cages may further include a cage housing that has an inflow end and an outflow end. The cage housing further includes a front panel, a rear panel, and opposed side panels that extend between the front and rear panels. The front panel, rear panel, and opposed side panels define a passageway that extends through an interior space formed by the front, rear, and opposed side panels and between the inflow end and the outflow end. The IT equipment may include at least one high-performance chip coupled to the rear panel of the cage housing. Each of the plurality of IT cages is immersed in cooling fluid within the first cooling chamber and the heated cooling fluid within the second cooling chamber, and wherein the cooling fluid from the first cooling chamber flows through each of the plurality of IT cages to the second cooling chamber; and/or
each of the plurality of cages further comprises a localized flow mechanism extending through the substantially continuous planar surfaces, the localized flow mechanism configured to draw cooling fluid from within first cooling chamber into the passageway; and/or
a cooling fluid supply manifold may be configured to supply cooling fluid to the first cooling chamber, wherein the cooling fluid supply manifold is an only supply cooling fluid supply manifold in the system; and/or
further including a second fluid supply manifold, the second fluid supply manifold supplying targeted cooling directly to IT components on the trays; and/or
the opposed side surfaces of the partition chamber wall are substantially continuous planar surfaces, such that cooling fluid does not pass through the planar surfaces.

According to another aspect of the disclosure, a system for cooling information technology ("IT") equipment includes an immersion unit, a cooling fluid, a heated cooling fluid, and a plurality of IT cages. The immersion unit of the system further includes a tank enclosure, a first cooling chamber, a second cooling chamber, and a partition chamber wall. The cooling fluid may be disposed within the first cooling chamber and has a first temperature. The heated cooling fluid within the second cooling chamber may have a second temperature greater than the first temperature. Each of the plurality of IT cages of the system can further include a cage housing that has an inflow end and an outflow end. The cage housing may further include a front panel, a rear panel, and opposed side panels that extend between the front and rear panels. The front, rear, and opposed side panels can further define a passageway that extends through an interior space formed by the front, rear, and opposed side panels and between the inflow end and the outflow end. The IT equipment may include at least one high-performance chip coupled to the rear panel of the cage housing. Each of the plurality of IT cages is immersed in cooling fluid within the first cooling chamber and the heated cooling fluid within the second cooling chamber, and wherein the cooling fluid from the first cooling chamber flows through each of the plurality of IT cages to the second cooling chamber.

Unless otherwise stated, the foregoing alternative examples are not mutually exclusive, but may be implemented in various combinations to achieve unique advantages. As these and other variations and combinations of the features discussed above can be utilized without departing from the subject matter defined by the claims, the foregoing description should be taken by way of illustration rather than by way of limitation of the subject matter defined by the claims. In addition, the provision of the examples described herein, as well as clauses phrased as "such as," "including," and the like, should not be interpreted as limiting the subject matter of the claims to the specific examples; rather, the examples are intended to illustrate only one of many possible implementations. Further, the same or similar reference numbers in different drawings can identify the same or similar elements.

## Claims

1. An information technology (IT) cage for immersion liquid cooling, comprising:
a cage housing having an inflow end and an outflow end, the cage housing defining a primary internal passageway configured to allow a passive bulk flow of a cooling fluid from the inflow end to the outflow end;
IT equipment housed within the primary internal passageway of the cage housing, the IT equipment comprising at least one primary heat-generating component and at least one secondary component positioned downstream of the at least one primary heat-generating component relative to the passive bulk flow; and
a localized cooling sub-system coupled to the cage housing, the localized cooling sub-system comprising a targeted cooling device configured to draw a secondary flow of the cooling fluid from an exterior of the cage housing,
wherein the localized cooling sub-system is oriented to direct the secondary flow of the cooling fluid toward the at least one secondary component to bypass the passive bulk flow heated by the at least one primary heat-generating component.

2. The IT cage of claim 1, wherein the localized cooling sub-system further comprises:
a first internal dedicated line disposed within the cage housing and fluidly coupled to the targeted cooling device;
a first fluid distribution element coupled to the first internal dedicated line and positioned adjacent the at least one secondary component; and
a first control valve coupled to the first internal dedicated line and configured to regulate a distribution of the secondary flow of the cooling fluid toward the at least one secondary component.

3. The IT cage of any one of claims 1 or 2, wherein the localized cooling sub-system further comprises:
a second internal dedicated line disposed within the cage housing and fluidly coupled to the targeted cooling device; a second fluid distribution element coupled to the second internal dedicated line and positioned upstream of the at least one primary heat-generating component; and
a second control valve coupled to the second internal dedicated line and configured to regulate a distribution of the secondary flow of the cooling fluid onto the at least one primary heat-generating component.

4. The IT cage of any one of claims 1 to 3, wherein the targeted cooling device comprises a pump coupled to the cage housing; and/or
wherein the targeted cooling device comprises a supply line connector configured to removably couple with a secondary supply manifold positioned external to the cage housing.

5. The IT cage of any one of claims 2 to 4, wherein the first fluid distribution element comprises a nozzle oriented to inject the secondary flow into the primary internal passageway at a higher pressure than a pressure of the passive bulk flow.

6. The IT cage of any one of claims 2 to 5, further comprising a valve controller in communication with the first control valve, the valve controller configured to automatically adjust an opening size of the first control valve based on temperature telemetry data associated with the at least one secondary component.

7. The IT cage of any one of claims 1 to 6, wherein the at least one primary heat-generating component comprises a microelectronic processor, and the secondary component is positioned nearer to the outflow end of the cage housing than the microelectronic processor; and
wherein optionally the at least one primary heat-generating component is adjacent a cold plate.

8. The IT cage of any one of claims 1 to 7, wherein the targeted cooling device is positioned at a vertical height along the cage housing that is lower than a vertical height of the at least one secondary component.

9. A system for cooling information technology (IT) equipment, comprising:
an immersion cooling unit comprising a tank enclosure having an interior space containing a volume of a cooling fluid; and
at least one IT cage according to any one of claims 1 to 8, the at least one IT cage positioned within the interior space and at least partially submerged within the cooling fluid.

10. The system of claim 9, wherein the localized cooling sub-system further comprises internal piping fluidly coupled to the targeted cooling device and at least one control valve situated on the internal piping to regulate a flow rate of the localized portion of the cooling fluid.

11. The system of any one of claims 9 to 10, wherein the interior space of the immersion cooling unit comprises a first cooling chamber, a second cooling chamber, and a partition chamber wall separating the first cooling chamber from the second cooling chamber; and
wherein optionally the at least one IT cage is positioned through an opening in the partition chamber wall such that the inflow end is located within the first cooling chamber, the outflow end is located within the second cooling chamber, and the targeted cooling device is positioned on an exterior of the cage housing at a vertical height entirely within the first cooling chamber.

12. The system of any one of claims 9 to 11, further comprising a secondary fluid supply manifold positioned within the interior space of the immersion cooling unit, wherein the targeted cooling device of the at least one IT cage comprises a connector removably coupled to the secondary fluid supply manifold to receive the localized portion of the cooling fluid; and/or
further comprising a programmable logic controller (PLC) and at least one temperature sensor positioned adjacent the secondary downstream component, the PLC configured to:
receive actual temperature data from the at least one temperature sensor;
determine whether the actual temperature data falls outside a predetermined temperature setpoint range; and
transmit an instruction to automatically adjust a flow rate of the localized cooling sub-system; and/or
wherein the at least one IT cage further comprises a closed-loop cold plate assembly thermally coupled to the primary heat-generating component, the closed-loop cold plate assembly configured to receive a secondary cooling fluid from a source external to the tank enclosure, the secondary cooling fluid having a different fluid composition than the cooling fluid contained in the interior space.

13. An immersion unit for immersion liquid cooling comprising:
a tank enclosure having an interior space configured for immersion of information technology ("IT") equipment within the tank enclosure;
a first cooling chamber having an inlet for receiving cooling fluid from a cooling fluid supply external to the tank enclosure;
a second cooling chamber having an outlet for recirculating heated cooling fluid within the second cooling chamber to the external cooling fluid supply, the heated cooling fluid being cooling fluid from the first cooling chamber that is increased in temperature due to convention; and
a partition chamber wall positioned within the interior space and having a top surface and a bottom surface, the petition chamber wall extending substantially across a length and width of the interior space and separating the interior space into the first cooling chamber and the second cooling chamber, such that the top surface of the partition chamber wall defines a bottom surface of the second cooling chamber and the bottom surface of the partition chamber wall defines a top surface of the first cooling chamber, the partition chamber wall having a plurality of wall openings extending through top and bottom surfaces of the partition chamber wall,
wherein the partition chamber wall is configured to receive a plurality of IT cages housing the IT equipment and positioned within a corresponding one of the plurality of wall openings, the partition chamber wall being configured to allow for each of the plurality of IT cages to be positioned within the first cooling chamber and the second cooling chamber at the same time during immersion cooling.

14. The immersion unit of claim 13, wherein the partition chamber wall further includes a plurality of panels, wherein each of the plurality of panels overlies a corresponding one of the plurality of openings, each of the plurality of panels being configured to move from a closed position where the corresponding opening is closed and cooling fluid is unable to pass therethrough, and an open position where the corresponding opening is open and cooling fluid can pass therethrough.

15. The immersion unit of any one of claims 13 to 14, wherein each of the plurality of panels is a single panel and each single panel overlies the corresponding one of the plurality of openings, wherein each of the plurality of openings has a width, and each single panel has a length that is equal to or greater than the width.
